# EUROPEAN PATENT APPLICATION

(11) **EP 3 626 865 A1**
(43) Date of publication of application: **25.03.2020**
(21) Application number: 18195606.1
(22) Date of filing: 20.09.2018
(51) Int. Cl.: C30B 25/12, C23C 16/458, H01L 21/687, C23C 16/32, C23C 16/04

(54) **SUSCEPTOR AND METHOD FOR MANUFACTURING THE SAME**

(71) Applicant: Heraeus GMSI LLC, Tempe, AZ 85284 (US)
(72) Inventor: Amos, James M., Apache Junction, AZ Arizona 85120 (US); Dillman, Rex, Mesa, AZ Arizona 85203 (US)
(74) Representative: Gille Hrabal

(57) **Abstract**

The invention relates to a new susceptor and a process for manufacturing the same. The new susceptor of the invention comprises at least one structured area for positioning articles for high temperature applications, components for applied materials, components for chip manufacturing etc., such as wafer, semiconductor materials, electronic components etc. thereon, the structured area being constituted by a plurality of adjacent placing elements of essentially equal height and having an overall surface, constituted by said placing elements, being convex or concave. The susceptor of the invention may comprise a graphite substrate coated with silicon carbide (SiC). A further aspect of the invention relates to a process for preparing the new susceptor and to the use thereof for manufacturing articles for high temperature applications, components for applied materials, components for chip manufacturing, such as wafer, semiconductor materials, electronic components etc., by placing the articles on the susceptor and subjecting it to the desired high temperature treatment.

## Description

The invention relates to a new susceptor and a process for manufacturing the same. The new susceptor of the invention comprises at least one structured area for positioning articles for high temperature applications, components for applied materials, components for chip manufacturing, such as wafer, semiconductor materials, electronic components, preferably a wafer, thereon, the structured area being constituted by a plurality of adjacent placing elements of essentially equal height and having an overall surface, constituted by said placing elements, being convex or concave. The susceptor of the invention may comprise a graphite substrate coated with silicon carbide (SiC). A further aspect of the invention relates to a process for preparing the new susceptor and to the use thereof for manufacturing articles for high temperature applications, components for applied materials, components for chip manufacturing, such as wafer, semiconductor materials, electronic components etc., by placing the articles on the susceptor and subjecting it to the desired high temperature treatment.

### Background of the Invention

Susceptors are important tools in high temperature applications when manufacturing articles or components for applied materials, in chip manufacturing etc. such as wafer, semiconductor materials, electronic components etc..

One important aspect of such applications relates to the application of coatings or semiconductor films onto the articles or components. For common semiconductor films such as silicon nitride, polysilicon, and thermal oxides, as well as for silicon carbide coatings, substrate processing usually proceeds by elevating the substrate to some process temperature, conducting the process, and finally cooling the substrate. Generally, most processes are conducted in a furnace where the components to be treated are placed in a vertically stacked arrangement. Because of process and throughput requirements, the stacked components (e.g. wafer) often undergo rapid heating and cooling at the beginning and end of the process. The gravitational force and elevated process temperature (typically above 850 °C) cause considerable stress on the components (e.g. the silica on wafers), leading to situations where slip and plastic deformation may occur. Fast thermal ramping can further degrade the situation because thermal gradients from uneven heating of components (e.g. wafers) in a vertical stacked arrangement may cause slip to occur even before the process temperature is reached. Fast thermal ramping is employed to increase productivity by decreasing the overall cycle time or reduce thermal budget by decreasing the ramping cycles.

A particular aspect of such high temperature applications relates to chemical vapor deposition methods (CVD), wherein a silicon carbide (SiC) coating is deposited on a substrate, e.g. a wafer in a semiconductor manufacturing process. Usually, in a CVD method, a wafer is placed on a susceptor made of SiC or the like and a uniform process gas is supplied to the wafer while the wafer is being heated and rotated to form an SiC film on the wafer. However, when the wafer is heated and a process gas is supplied thereto, the SiC may also deposit on members other than on the wafer, which may cause the wafer to be stuck on the susceptor. When removing the coated wafer from the susceptor, fractures and particles may then occur, which have to be avoided in high precision devices, thus resulting in low yield and reliability. Also sliding of the wafer on the susceptor surface can occur, which is disadvantageous for similar reasons.

It is further important to provide an optimal heat transfer from the susceptor to the component to be treated thereon (e.g. the wafer) during processing to keep thermal stress and fractures or defects resulting therefrom as low as possible. Further, during the manufacturing process of a wafer, warping of the wafer occurs due to the heating, which leads to insufficient contact of the wafer over its whole surface with the susceptor throughout the whole process. This deteriorates the heat transfer during the process. Further, the warping may cause mechanical stress on the wafer due to missing support from the contact surface in the warped regions.

To avoid the above described problems, it has been described to provide susceptors on which a kind of pocket or boat is formed into which the wafer is placed. Such pocket or boat may be in the form of a lowered (planar) contact surface on the susceptor or in the form of a circular concavity, into which the wafer is placed. By adjusting the size of the pocket to the size of the wafer to be placed therein, sliding of the wafer can be avoided. Further, it is possible to provide a concave / convex surface of the susceptor onto which the wafer is placed, such concave / convex surface allows to coincide with the warping of the wafer mounted thereon. Examples of susceptors providing a pocket or concavity for placing a wafer therein are described in US 2004/0040510 A1, US 2004/0109748 A1, US 2016/0281227 A1, KR 20000074400, and in EP 1396879 A1.

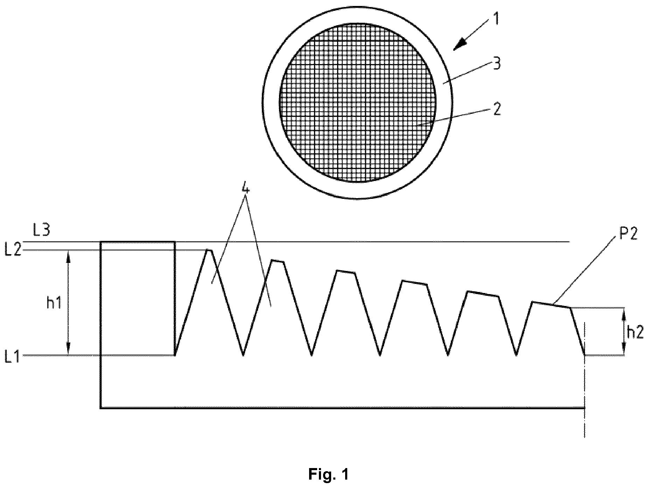

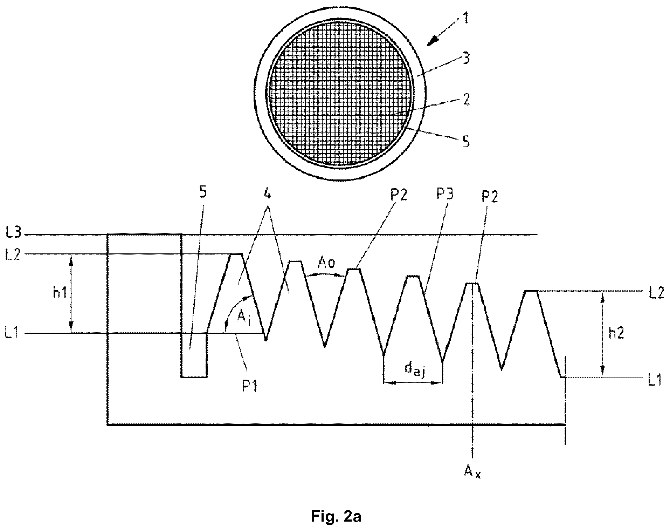

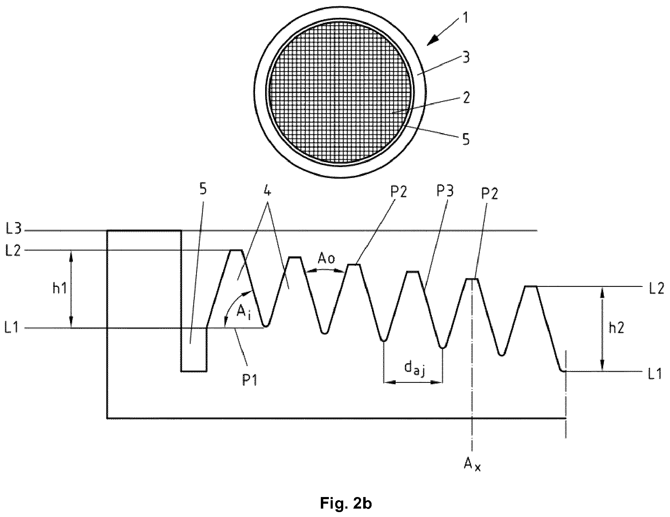

It has also been described to provide susceptors with uneven or structured surface, e.g. by providing risings or elevated punctual sections, for example by embossing a surface of the susceptor as described in US 2010/0163524 A1 or by providing a lattice shape or mesh-like grooves on the surface of the susceptor, as described in EP 1396879 A1 and in US 2010/0129990 A1. Such lattice shape may be in the form of a large number of convexities formed in a trapezoid shape as shown in figure 1A of EP 1396879 A1 and is described to prevent sliding of a wafer. The distance between the trapezoid convexities must be adjusted to maintain sufficient heat transfer from the bottom of the pocket to the wafer. Similarly, US 2010/0129990 A1 describes to provide a plurality of "convex" risings of the base material surrounded by grooves to form a structure of mesh-like grooves on the surface of a pocket in the susceptor as shown in figure 2A and 2B of US 2010/0129990 A1. It is described that the grooves surrounding the risings provide a path for the process gas and that the wafer can be easily dismounted from the susceptor when removing it. Such grooves surrounding the risings are configured to have a plane bottom area (1) between the risings as illustrated in Figure 1B of EP1396879 A1 or in case of directly adjacent risings are configured in the form of a "V" as illustrated in Fig. 1 of the present application. Further, sliding or displacement in mounting of the wafer shall be prevented by such lattice or mesh-like structure surrounded by grooves.

Although, these documents describe to provide a plurality of structured elements in a plane pocket of the susceptor, onto which the wafers are positioned, the overall surface onto which the wafer is positioned and which is constituted by the plurality of placing elements in the trapezoid or rectangle form as shown in figure 1A and 1B of EP 1396879 A1 or figure 2A and 2B of US 2010/0129990 A1 is flat or plane. Accordingly, when warping of the wafer occurs, the contact area between the wafer and the plurality of surfaces of the placing elements reduces, which deteriorates the heat transfer and does not allow a uniform heating and cooling of the wafer on the surface to which it is mounted during the whole process.

Further, susceptors are conventionally prepared, combining the above two elements of providing placing elements and an overall concave surface thereof. Such susceptors are usually prepared by first cutting the susceptor surface to provide the plurality of identical adjacent placing elements into the susceptor surface, similar as illustrated in figure 1A and 1B of EP 1396879 A1 or in figure 2B of US 2010/0129990 A1. Thereafter the thus regularly patterned surface is cut over the overall surface to provide a concave / convex form, leading to inclined surface areas of the placing elements and descending levels of said inclined surfaces of the placing elements onto which the wafer is mounted from the edge of the susceptor to the inner center thereof. Such process provides susceptors having a plurality of placing elements, each surrounded by grooves, which are configured to have a plane bottom area (1) between the placing elements or in case of directly adjacent placing elements are configured in "V"-form, and having an overall concave / convex surface in the form of a kind of pocket or cavity to house the wafer. Susceptors obtained by such a known method are illustrated in **Figure 1** of the present application.

However, as mentioned above, in particular for high temperature applications and when applied in high precision devices it is of particular importance to provide susceptors with the best possible heat transfer characteristics and safe positioning of the wafer to avoid the above described disadvantages of sliding and warping and further thermal stress, resulting in cracks, fractures and micro-defects in the wafer and semiconductor materials to be treated on the susceptor.

The inventors of the invention surprisingly found, that with the new susceptor as described herein, it is possible to reduce or even avoid the above described disadvantages of susceptors known so far.

### Object of the Invention

One object of the invention was to provide a new susceptor which avoids the disadvantages of the prior art.

A further object of the invention was to provide a new susceptor with improved heat transfer characteristics.

A further object of the invention was to provide a new susceptor which allows safe mounting of a wafer thereon and to avoid sliding of the wafer on the susceptor.

A further object of the invention was to provide a new susceptor preventing warping of the wafer on the susceptor.

A further object of the invention was to provide a new susceptor being able to coincide with possible warping of a wafer on the susceptor.

A further object of the invention was to provide a new susceptor being able to maintain optimum heat transfer and contact between the susceptor surface onto which the wafer is placed throughout the whole process, in case of possible warping of the wafer on the susceptor during the process.

A further object of the invention was to provide a new susceptor allowing the high temperature treatment of articles for high temperature applications, components for applied materials, components for chip manufacturing, such as wafer, semiconductor materials, electronic components etc., without or at least reduced formation of cracks, spallings, fractions and/or micro-defects in the treated components.

A further object of the invention was to provide a new susceptor comprising a graphite substrate with a SiC coating of improved mechanical stability, quality and/or connectivity between the SiC coating and the underlying graphite substrate.

A further object of the invention was to provide a new susceptor comprising a graphite substrate with a SiC coating, wherein the SiC coating forms a tightly connected layer on the underlying graphite substrate.

A further object of the invention was to provide a new susceptor comprising a graphite substrate with a SiC coating, wherein the SiC coating of the susceptor exhibits on the one hand sufficient mechanical resistance and strength and on the other hand a maximum of continuity and homogeneity.

A further object of the invention was to provide a new susceptor comprising a graphite substrate with a SiC coating, having improved averaged coefficient of thermal expansion between the graphite substrate and the SiC coating layer.

A further object of the invention was to provide a new susceptor comprising a graphite substrate with a SiC coating, having improved residual compressive load in the SiC layer.

A further object of the invention was to provide a new susceptor comprising a graphite substrate with a SiC coating, having improved impact resistance.

A further object of the invention was to provide a new susceptor comprising a graphite substrate with a SiC coating, having improved fracture toughness.

A further object of the invention was to provide a new susceptor comprising a graphite substrate with a SiC coating, having improved adhesion between the graphite substrate and the SiC coating layer.

A further object of the invention was to provide a new susceptor comprising a graphite substrate with a SiC coating, exhibiting an outer surface of a SiC coating layer and an interfacial layer being formed by SiC tendrils extending into the porous graphite substrate and being located between the graphite substrate and the outer SiC layer.

A further object of the invention was to provide a new susceptor comprising a graphite substrate with a SiC coating, exhibiting improved relation between the size of the outer surface of the SiC coating layer to the size of the interfacial layer being formed by the SiC tendrils extending into the porous graphite substrate.

A further object of the invention was to provide a new susceptor comprising a graphite substrate with a multilayer SiC coating.

A further object of the invention was to provide a new susceptor comprising a graphite substrate with a multilayer SiC coating, wherein at least two SiC layers of different porosity and/or density are present.

A further object of the invention was to provide a new process for preparing such a new susceptor according to the invention.

A further object of the invention was to provide a new and improved susceptor with particular suitability for the use and the high temperature applications as described herein.

The inventors of the invention surprisingly found that these objects can be solved with the new susceptor and the new process according to the invention, which are described in detail as follows.

### Preferred Embodiments of the Invention

The independent claims describe embodiments of the invention for solving at least one of the above mentioned objects of the invention. The dependent claims provide further preferred embodiments, which contribute to solving at least one of the above mentioned objects of the invention.
[1] Susceptor (1), comprising
   a) at least one structured area (2) having a structured surface for positioning articles for high temperature applications, components for applied materials, components for chip manufacturing, such as wafer, semiconductor materials, electronic components, preferably a wafer, thereon, and
   b) an unstructured area (3) surrounding the at least one structured area (2),
      wherein
      I) the at least one structured area (2) is constituted by a plurality of placing elements (4),
         i. wherein the placing elements (4) are arranged adjacent to each other and wherein
         ii. each placing element (4) comprises a bottom plane (P1) on a bottom level (L1) and a top plane (P2) on an upper level (L2), and
         iii. the perpendicular height (h) from the bottom plane (P1) on the bottom level (L1) to the top plane (P2) on the upper level (L2) is essentially equal for all placing elements (4) and
      II) the overall surface constituted by the placing elements (4) of the at least one structured area (2) on the susceptor (1) is convex or concave.
[2] Susceptor according to embodiment [1], wherein the placing elements (4) have the form of a frustum.
[3] Susceptor according to anyone of the preceding embodiments, wherein the surface area of the top planes (P2) is essentially equal for all placing elements (4).
[4] Susceptor according to anyone of the preceding embodiments, wherein the frustum contour of the placing elements (4) is a squared frustum.
[5] Susceptor according to any one of the preceding embodiments, wherein the surface area of the top planes (P2) of each placing element (4) is between 0.0025 and 0.25mm², preferably between 0.01 and 0.16 mm².
[6] Susceptor according to any one of the preceding embodiments, wherein the central axes (Aₓ) of the placing elements (4) are parallel to each other.
[7] Susceptor according to any one of the preceding embodiments, wherein the bottom level (L1) of the bottom planes (P1) of the placing elements (4) is below the surface level (L3) of the unstructured area (3).
[8] Susceptor according to any one of the preceding embodiments, wherein the surface level (L3) of the unstructured area (3) is equal to and/or higher than the upper level (L2) of the top planes (P2) of the placing elements (4).
[9] Susceptor according to any one of the preceding embodiments, wherein the bottom level (L1) of the bottom plane (P1) of the placing elements (4) is gradually descending, relative to the surface level (L3) of the unstructured area (3), from the outer edge to the center of the structured area (2).
[10] Susceptor according to any one of the preceding embodiments, wherein the inner angle (Aᵢ) between the bottom plane (P1) and the side planes (P3) of the placing elements (4) is equal to or smaller than 90°.
[11] Susceptor according to any one of the preceding embodiments, wherein the placing elements (4) have the form of a frustum with an inner angle (Aᵢ) between the bottom plane (P1) and the side planes (P3) of the frustum being < 90°, preferably having an inner angle (Aᵢ) of between 30° and 80°, preferably 35° and 70°, preferably 35° and 60°.
[12] Susceptor according to any one of the preceding embodiments, wherein the space between two adjacent placing elements (4) on the bottom level (L1) has a curved configuration.
[13] Susceptor according to any one of the preceding embodiments, wherein the distance (dₐⱼ) between the spaces of two adjacent placing elements (4) on the bottom level (L1) is between 0.10 to 10.00 mm, preferably 0.20 to 8.00 mm, preferably 0.30 to 7.00 mm, preferably 0.40 to 6.00 mm.
[14] Susceptor according to any one of the preceding embodiments, wherein the outer angle (Aₒ) between two adjacent placing elements (4), which spans via the space between the two adjacent placing elements, is between 140° and 45°, preferably 120° and 60°, preferably 110° and 70°.
[15] Susceptor according to any one of the preceding embodiments, wherein the perpendicular height from the bottom plane (P1) on the bottom level (L1) to the top plane (P2) on the upper level (L2) for all placing elements (4) is in the range of 0.05 to 0.70 mm, preferably 0.10 to 0.60 mm.
[16] Susceptor according to any one of the preceding embodiments, comprising two, three or more identical or different structured areas (2) for positioning articles for high temperature applications, components for applied materials, components for chip manufacturing, such as wafer, semiconductor materials, electronic components, preferably a wafer, thereon.
[17] Susceptor according to any one of the preceding embodiments, wherein each structured area (2) is surrounded by a groove (5), preferably by a groove having a curved configuration.
[18] Susceptor according to embodiment [17], wherein the groove (5) surrounding the at least one structured area (2) has a depth of 0.2 to 1.5 mm, preferably 0.3 to 1.3 mm.
[19] Susceptor according to embodiment [17] or [18], wherein the groove (5) surrounding the at least one structured area (2) has a width or in case of a curved groove a diameter of 0.2 to 1.5 mm, preferably 0.3 to 1.3 mm.
[20] Susceptor according to any one of the preceding embodiments, wherein the susceptor comprises a graphite substrate.
[21] The susceptor according to any one of the preceding claims, which is coated with silicon carbide (SiC).
[22] The susceptor according to embodiment [20] or [21], wherein the susceptor comprises a porous graphite substrate having an open porosity of ≥ 6 % and ≤ 15 %, preferably 6 % to 13 %, more preferably 11 to 13 %, which is coated with a SiC coating layer, and which has an interfacial layer located between the graphite substrate and the SiC coating layer comprising the porous graphite and pores filled with SiC in the form of tendrils of at least 50 µm length, extending from the SiC coating layer into the porous graphite substrate.
[23] A process for preparing the susceptor (1) as defined in any one of the preceding embodiments comprising the steps
   (A) providing a graphite substrate
   (B) cutting at least one structured area (2) into the surface of the graphite substrate, wherein the cutting is performed to provide a plurality of placing elements (4) as defined in any one of the preceding embodiments
   (C) followed by cutting the overall surface of the at least one structured area (2) of step (B) into a convex or concave form.
[24] The process according to embodiment [23], further comprising a step of cutting a groove (5) surrounding the at least one structured area (2) into the surface of the graphite substrate.
[25] The process according to embodiment [23] or [24], wherein the cutting is carried out using a laser, a molding cutter or a rotary cutter.
[26] The process according any one of the embodiments [23] to [25], further comprising a step (D) of coating the susceptor (1) with SiC.
[27] The process according to embodiment [26] wherein in step (D) the SiC coating is carried out using chemical vapor deposition (CVD) with dimethyldichlorosilane (DMS) as the CVD precursor material.
[28] The process according to any one of the embodiments [26] to [27], wherein prior to step (D) the graphite substrate is subjected to a purification treatment comprising a heat treatment with nitrogen as purge gas in an atmosphere comprising 5.0 to ≤ 0.5 % oxygen and a chlorination treatment at elevated temperatures.
[29] The process according to any one of the embodiments [26] to [28], wherein prior to step (D) the graphite substrate is subjected to an activation treatment comprising a heat treatment with nitrogen as purge gas in an atmosphere comprising 5.0 to ≤ 0.5 % oxygen directly followed by the CVD treatment of step (D) carried out in the same process chamber.
[30] The process according to any one of the embodiments [23] to [29], wherein the graphite substrate subjected to the SiC coating is a purified and/or activated graphite substrate with a modified surface porosity having a chlorine content of at least about 20.00 ppb wt., preferably at least about 40.00 ppb wt., preferably about 60.00 ppb wt..
[31] The process according to embodiment [30], wherein the chlorine is present in the porous graphite substrate ≥ 50 µm below the main surface of the graphite substrate.
[32] The process according to any one of the embodiments [23] to [31], wherein the graphite substrate subjected to the SiC coating has an open porosity with a porosity degree of ≥ 6 % and ≤ 15 %, preferably about 6 % to about 13 %, preferably of about 11 % to about 13 %.
[33] The use of the susceptor (1) according to anyone of the embodiments [1] to [22]or as obtainable in a process according to anyone of the embodiments [23] to [32] for manufacturing articles for high temperature applications, components for applied materials, components for chip manufacturing etc. such as wafer, semiconductor materials, electronic components etc.
[33] The use of the susceptor (1) according to anyone of the embodiments [1] to [22]or as obtainable in a process according to anyone of the embodiments [23] to [32] for holding a wafer, semiconductor materials, components for chip manufacturing etc. by placing the wafer, semiconductor materials, components for chip manufacturing etc. on the top planes (P2) of the placing elements (4) constituting the surface of the structured area (2) in high temperature treatments.

### Detailed Description of the Invention

### I. Definitions

In the following description given ranges include the lower and upper threshold values. Accordingly, a definition in the sense of "in the range of X and Y" or "in the range between X and Y" of a parameter A means, that A can be any value of X, Y and any value between X and Y. Definitions in the sense of "up to Y" or "at least X" of a parameter A means, that accordingly A may be any value less than Y and Y, or A may be X and any value greater than X, respectively.

In the sense of the invention the term "essential" or "essentially" in context with a geometric or metric feature indicates identity with a deviation of not more than 1.0 %, preferably not more than 0.5 %, more preferably not more than 0.1 %.

In the sense of the invention the term "tendril" or "tendrils" describes deposited SiC material, having a specific length and extending from the surface of a porous substrate into the pores, thereby providing a deep-reaching anchor- or hook-like solid connection between an outer SiC layer extending over the surface of a porous substrate with the porous substrate.

In the sense of the invention "porosity" relates to "open porosity", otherwise the growing of the SiC tendrils into the porous graphite substrate would not be possible.

Scanning Electron Microscope (SEM) measurement, as mentioned in the invention as a determination method e.g. for determination of porosity degree, pore modification, SiC particle sizes, interfacial layer thickness etc., preferably relates to a SEM system using Phenom ProX (5 kV, 10 kV and 15 kV) at room temperature (appr. 24 °C).

### II. Susceptor

A first aspect of the invention relates to a new susceptor.

The new susceptor (1) of the invention comprises
a) at least one structured area (2) having a structured surface for positioning articles for high temperature applications, components for applied materials or components for chip manufacturing thereon, and
b) an unstructured area (3) surrounding the at least one structured area (2),
   wherein
   I) the at least one structured area (2) is constituted by a plurality of placing elements (4),
      i. wherein the placing elements (4) are arranged adjacent to each other and wherein
      ii. each placing element (4) comprises a bottom plane (P1) on a bottom level (L1) and a top plane (P2) on an upper level (L2), and
      iii. the perpendicular height (h) from the bottom plane (P1) on the bottom level (L1) to the top plane (P2) on the upper level (L2) is essentially equal for all placing elements (4) and
   II) the overall surface constituted by the placing elements (4) of the at least one structured area (2) on the susceptor (1) is convex or concave.

Articles for high temperature applications, components for applied materials and components for chip manufacturing, which can be positioned on the susceptor of the invention, comprise common articles and components of the electronic technology field and high precision components which have to be subjected to processing under varying temperature influence, in particular high temperature applications (hereinafter also shortly referred to as "the components" or "the components placed thereon/on the susceptor/on the structured area" or "the components to be processed"). Such processes and the suitable fields of application of susceptors are well known to a skilled person. Particular examples of such components to be processed on a susceptor include (without being limited thereto) wafer, semiconductor materials, electronic components, etc. Preferably, the susceptor of the invention is used for positioning a wafer thereon.

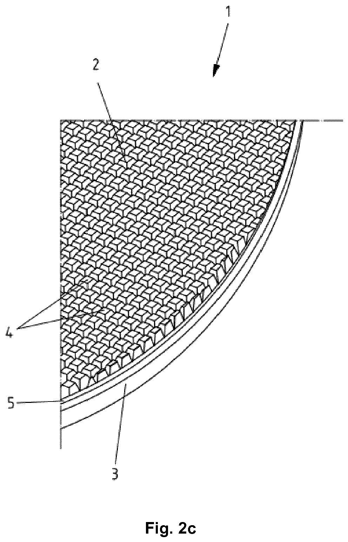

A susceptor according to the invention comprising the features as described above is illustrated in **Figure 2****.**

The new susceptor of the invention comprises at least one structured area (2), which is constituted by a plurality of placing elements (4), which are arranged adjacent to each other. Adjacent arrangement preferably means a symmetric arrangement of the placing elements. Such adjacent placing elements can be provided in the susceptor by cutting a plurality of symmetric intersecting grooves into the surface of the susceptor. By carrying out such cutting only on one or more discrete area(s) of the susceptor surface the one or more structured area(s) can be obtained, which are surrounded by the remaining uncut susceptor surface, which thus constitutes the unstructured area (3) of the susceptor of the invention.

The susceptor according to the invention may comprise one to two, one to three, one to four, or even more, i.e. one, two, three, four or even more identical or different structured areas (2) for positioning a component to be processed thereon. In the following reference may be made to "one structured area", which indicates that the respective description or definition relates to the structured area in the case of only one structured area present in the susceptor or to at least one of the structured area(s) in case of multiple structured areas present in the susceptor. This means, that in a susceptor comprising more than one structured areas some or all structured areas may be designed in the same manner or may be different. A susceptor with multiple structured areas may for example comprise structured areas, which differ from each other in one or more of the specific features described below in detail, such as e.g. may comprise different forms and/or sizes of and/or distances between the placing elements etc.. Preferably, in the case of multiple structured areas all structured areas of the susceptor are designed in the same manner.

In the new susceptor of the invention the placing elements constituting one structured area of the susceptor are essentially equal. This means that in particular each placing element constituting a structured area of the susceptor has the same geometric form or contour.

Very particularly all placing elements constituting one structured area of the susceptor have essentially the same perpendicular height, measured from the bottom plane (P1) on the bottom level (L1) to the top plane (P2) on the upper level (L2).

Further, the overall surface of the at least one structured area (2), being constituted by the placing elements (4), on the susceptor (1) is convex or concave. Preferably the overall surface of the at least one structured area, constituted by the placing elements (4), is concave, thus providing a kind of pocket or bowl on the surface of the susceptor wherein the articles for high temperature applications, such as in particular a wafer, can be placed.

Usually, such concave overall surface is achieved by cutting the tops of the plurality of identical and adjacent placing elements with increasing cutting-depth from the edge of the structured area to its center. This, however mandatorily results in placing elements having decreasing height with higher placing elements at the edges of the structured area and the smallest height in its center. This is disadvantageous under the viewpoint of uniform heat distribution and heat transfer through the material of the susceptor and of the placing elements onto which the articles for high temperature applications, such as in particular a wafer, are placed during processing. It is apparent that placing elements with smaller height, located in the center of the structure concave area, will provide faster and higher heat transfer than the placing elements with the biggest height located at the edges of the structure concave area. However, as mentioned above, uniform and constant heat transfer is an essential precondition for providing high quality, high performance components for chip manufacturing, such as wafer, semiconductor materials, electronic components etc..

The inventors of the invention surprisingly found that with the susceptor of the invention, comprising placing elements (4) with equal perpendicular height (h) from the bottom plane (P1) on the bottom level (L1) to the top plane (P2) on the upper level (L2) in a structured area of the susceptor, and at the same time providing the concave overall structure of said structured area, it became possible to provide a susceptor with improved heat transfer and heat distribution properties due to improved heat transfer conditions in the susceptor and placing elements material and by allowing to coincide with warping and at the same time prevent sliding of the articles positioned on the susceptor.

A further aspect of the invention relates to a susceptor as described herein, wherein the placing elements (4) have the form of a frustum. The inventors of the invention further found that surprisingly placing elements (4) having the form or contour of a frustum are particularly suitable to further improve the heat transfer and support uniform heat distribution through the susceptor and placing elements material. A frustum in the sense of the invention means a placing element having the frustum geometry in the common sense. This means, a frustum is the portion of a solid (normally a cone or pyramid) that lies between one or two (essentially) parallel planes cutting it. A right frustum is a parallel truncation of a right pyramid or right cone. The frustum comprises a lower bottom plane at a bottom level, which is bigger than the top plane on the upper level above the bottom level. Its axis if any, is that of the original cone or pyramid. The base of a frustum of the pyramid-type can be trilateral, quadrilateral, or any polygon shape. The frustum may also be circular if it has circular bases. However, a frustum of the pyramid-type is preferred. Particularly preferred are quadrilateral frustums. Most preferred is a squared frustum. Accordingly, a further aspect of the invention relates to a susceptor as described anywhere herein, wherein the placing elements (4) constituting a structured area (2) have the form of a squared frustum. When the placing elements, constituting a structured area, are in the form of frustums, then the grooves or spaces surrounding and dividing the placing elements from each other exhibit a shape with narrow distance at the bottom level of the placing elements and increasing distance to the upper level at the top planes of the placing elements. Such funnel shaped grooves provide better heat transfer and heat distribution from the bottom of the susceptor into the placing elements up to the top planes of the placing elements which are in direct contact with the components placed thereon. In principle, such grooves or spaces surrounding and dividing the placing elements from each other may have a "V"-form, as illustrated e.g. in Figure 2a of the present application, or a plane bottom dividing two placing elements from each other such as shown in the prior art as discussed herein. However, in a particularly preferred embodiment such grooves or spaces surrounding and dividing the placing elements from each other have a curved configuration. Such curved configuration results in particular in a curved bottom of the space between two adjacent placing elements, i.e. in particular a curved configuration of the space at the bottom level (L1), as illustrated e.g. in Figure 2b of the present application. Compared to a space having a "V"-form (as illustrated e.g. in Figure 1 or in Figure 2a of the present application) or a space or groove having a plane bottom (as illustrated e.g. in Figure 1B of EP1396879 A1) the preferred curved space between two adjacent placing elements has turned out as surprisingly advantageous by reducing the aerodynamic drag of the air or gas flowing between the placing elements underneath the wafer positioned thereon.

In the susceptor of the invention the surface area of the top planes (P2) is essentially equal for all placing elements (4) in one structured area. An essentially equal surface area in particular means equal size of the surface areas. This also improves and supports uniform heat transfer and heat distribution at any position where the components for chip manufacturing, such as wafer, semiconductor materials, electronic components etc. are in contact with the placing elements.

A further aspect of the invention relates to a susceptor as described herein, wherein the surface area of the top planes (P2) of each placing element (4) in one structured area is between 0.0025 and 0.25 mm², preferably between 0.01 and 0.16 mm². This range provides optimum heat transfer and heat distribution to the components placed thereon and at the same time provides sufficiently reduced contact points which still allow to remove the treated components easily without fractures or defects. As mentioned above, preferably all placing elements of one structured area of the susceptor have the same area size.

In a further aspect of the invention the bottom plane (P1) and the top plane (P2) of each placing element (4) in one structured area (2) is essentially parallel to each other. Due to the cutting of the concave shape into the surface of the structured area, the top plane and the bottom plane may not be ideally parallel, however the cutting of the concave shape is controlled to provide an overall concave shape which is sufficiently apparent to allow safe positioning of the components to be placed thereon but at the same time lead to only marginal gradient on the surface of each placing element.

In the susceptor according to invention the central axes (Ax) of the individual placing elements (4) in one structured area are parallel to each other.

As in the susceptor of the invention the overall surface of the structured area(s) preferably has a concave shape as described above, the bottom level (L1) of the bottom planes (P1) of the placing elements (4) constitution such structured area is below the surface level (L3) of the unstructured area (3). This results from cutting the placing elements and thereafter the concave shape into the plane surface of the susceptor material.

For the same reasons in the susceptor according to the invention the surface level (L3) of the unstructured area (3), surrounding the structured area (2), is equal to or higher than the upper level (L2) of the top planes (P2) of the placing elements (4) at the outer edge of the structured area and is higher than the upper level (L2) of the top planes (P2) of the placing elements (4) in the direction to the center of the structured area.

In a further aspect the susceptor of the invention exhibits equal placing elements in a structured area, wherein the bottom level (L1) of the bottom plane (P1) of the placing elements is gradually descending, relative to the surface level (L3) of the unstructured area, from the outer edge to the center of the structured area. Therewith, a plurality of placing elements, constituting the structured area of the susceptor of the invention, can be provided, which all have equal height and at the same time provide the preferred overall surface of the structured area constituted by the placing elements in a concave shape.

In a further aspect the susceptor of the invention comprises placing elements in a structured area, wherein the inner angle (Aᵢ) between the bottom plane (P1) and the side planes (P3) of the placing elements (4) of the structured area is equal to or smaller than 90°. In the case of placing elements in the form of columns or of blocks the inner angle is essentially 90°. In the case of placing elements in the form of frustums the inner angle (Aᵢ) is < 90°.

In a further aspect the susceptor of the invention comprises placing elements in a structured area, wherein the placing elements in a structured area have the form of frustums with an inner angle (Aᵢ) between the bottom plane (P1) and the side planes (P3) of the frustum being < 90°, preferably having an inner angle (Aᵢ) of < 80°, preferably having an inner angle (Aᵢ) of < 70°, preferably having an inner angle (Aᵢ) of < 60°.

In a further aspect the susceptor of the invention comprises placing elements in a structured area, wherein the placing elements in a structured area have the form of frustums with an inner angle (Aᵢ) between the bottom plane (P1) and the side planes (P3) of the frustum being at least (≥) 30°, preferably at least (≥) 35°.

In a further aspect the susceptor of the invention comprises placing elements in a structured area, wherein the placing elements in a structured area have the form of frustums with an inner angle (Aᵢ) between the bottom plane (P1) and the side planes (P3) of the frustum of between 30° and 80°, preferably 35° and 70°, preferably 35° and 60°.

The selection of an inner angle between the bottom plane (P1) and the side planes (P3) of the placing elements within the above defined ranges is advantageous with respect to providing an ideal contact surface onto which the components are placed. With the selection of the appropriate inner angle of the placing elements the size of top plane surface and / or the height of the placing elements can be appropriately adjusted to provide contact surfaces of the placing elements having the desired heat transfer and heat distribution properties and allow safe positioning of the components thereon avoiding the above discussed disadvantages such as sliding or sticking to the contact surface.

In a further aspect the susceptor of the invention comprises at least one structured area constituted by a plurality of adjacent placing elements, wherein the distance (dₐⱼ) between the spaces of two adjacent placing elements on the bottom level (L1) is at least (≥) 0.10 mm, preferably at least (≥) 0.20 mm, preferably at least (≥) 0.30 mm, preferably at least (≥) 0.40 mm, preferably at least (≥) 0.50 mm.

In a further aspect the susceptor of the invention comprises at least one structured area constituted by a plurality of adjacent placing elements, wherein the distance (dₐⱼ) between the spaces of two adjacent placing elements on the bottom level (L1) is not more than (≤) 10.00 mm, preferably not more than (≤) 8.00 mm, preferably not more than (≤) 7.00 mm, preferably not more than (≤) 6.00 mm.

In a further aspect the susceptor of the invention comprises at least one structured area constituted by a plurality of adjacent placing elements, wherein the distance (dₐⱼ) between the spaces of two adjacent placing elements on the bottom level (L1) is between 0.10 to 10.00 mm, preferably 0.20 to 8.00 mm, preferably 0.30 to 7.00 mm, preferably 0.40 to 6.00 mm.

In a further aspect the susceptor of the invention comprises at least one structured area constituted by a plurality of adjacent placing elements, wherein the outer angle (Aₒ) between two adjacent placing elements (4), which spans via the space between the two adjacent placing elements, is not more than (≤) 140°, preferably not more than (≤) 120°, preferably not more than (≤) 110°.

In a further aspect the susceptor of the invention comprises at least one structured area constituted by a plurality of adjacent placing elements, wherein the outer angle (Aₒ) between two adjacent placing elements (4), which spans via the space between the two adjacent placing elements, is at least (≥) 45°, preferably at least (≥) 60°, preferably at least (≥) 70°.

In a further aspect the susceptor of the invention comprises at least one structured area constituted by a plurality of adjacent placing elements, wherein the outer angle (Aₒ) between two adjacent placing elements (4), which spans via the space between the two adjacent placing elements, is between 140° and 45°, preferably 120° and 60°, preferably 110° and 70°.

The selection of the distance and/or the particular outer angle (Aₒ) between the placing elements constituting the structured area within the above defined ranges is advantageous with respect to providing ideal grooves or channels between the placing elements to allow improved air or gas flow and heat transfer in the structured area onto which the components to be processed are placed.

In a further aspect the susceptor of the invention comprises placing elements in a structured area, having a perpendicular height from the bottom plane (P1) on the bottom level (L1) to the top plane (P2) on the upper level (L2) of at least (≥) 0.05 mm, preferably at least (≥) 0.10 mm, and which is equal for all placing elements of said structured area.

In a further aspect the susceptor of the invention comprises placing elements in a structured area, having a perpendicular height from the bottom plane (P1) on the bottom level (L1) to the top plane (P2) on the upper level (L2) of not more than (≤) 0.70 mm, preferably not more than (≤) 0.60 mm, and which is equal for all placing elements of said structured area.

In a further aspect the susceptor of the invention comprises placing elements in a structured area, having a perpendicular height from the bottom plane (P1) on the bottom level (L1) to the top plane (P2) on the upper level (L2) in the range of 0.05 to 0.70 mm, preferably 0.10 to 0.60 mm, and which is equal for all placing elements of said structured area.

A further aspect of the invention relates to the susceptor as described anywhere herein, wherein each structured area (2) for positioning a component to be processed thereon is surrounded by a groove (5).

Preferably such groove surrounding the structured area(s) (2) of the susceptor of the invention is cut in a curved configuration. This means that such particularly curved groove has a curved bottom and/or curved side walls.

Such groove (5) surrounding the at least one structured area (2) of the susceptor preferably has a depth of at least (≥) 0.2 mm, preferably at least (≥) 0.3 mm, or of not more than (≤) 1.5 mm, preferably not more than (≤) 1.3 mm, or of between 0.2 to 1.5 mm, preferably 0.3 to 1.3 mm.

In addition or alternatively, such groove (5) surrounding the at least one structured area (2) of the susceptor preferably has a width or in case of a curved groove a diameter of at least (≥) 0.2 mm, preferably at least (≥) 0.3 mm, or of not more than (≤) 1.5 mm, preferably not more than (≤) 1.3 mm, or of between 0.2 to 1.5 mm, preferably 0.3 to 1.3 mm.

Providing such an additional groove surrounding the at least one structured area is further advantageous with respect to the air or gas flow and air or gas exchange between the unstructured area (3) and the structured area (2). The surrounding groove (5) supports the introduction of the air or gas into the grooves and channels surrounding each individual placing elements and facilitates fast and uniform air or gas and heat distribution within the channels and grooves of the structured area. Further, the groove (5) supports the air or gas and heat exchange between the structured and the unstructured areas of the susceptor. The selection of the depth and/or width of said groove (5) within the above defined ranges is advantageous with respect to providing ideal conditions for air or gas and heat exchange, transfer and distribution over the susceptor.

The susceptor of the invention can in principle be constituted by any suitable susceptor substrate as known in the technical field of the invention. However, in a particular further aspect the susceptor of the invention as described anywhere herein is constituted by (or comprises) a graphite substrate. This means, that preferably the base material of the susceptor is graphite.

A graphite substrate, that constitutes the basis or core of the susceptor can be any suitable graphite element. The graphite can be cut into the desired size and shape of the susceptor, which can be varied according to the customers' needs and wishes. Preferably a graphite is used having at least 99 % purity. The graphite may be subjected to further treatments, such as in particular a surface treatment for providing the desired surface roughness and/or evenness.

In a further aspect of the invention the graphite substrate constituting the susceptor has an open porosity. It is preferred that the graphite substrate has a porosity degree of ≥ 6 % and ≤ 15 %. Preferably, the graphite substrate has a porosity degree of about > 6 % to < 15 % or a porosity in a range of about 6 % to about 14 %, about 6 % to about 13 %, about 6 % to < 13 %, or a porosity in a range of > 6 % to about 15 %, about 7 % to about 15 %, about 8 % to 15 %, about 9 % to about 15 %, about 10 % to about 15 %, about 11 % to about 15 %, or a porosity in a range of ≥ 11 % to about 13 %. The porosity degree can be determined using known methods, such as in particular by SEM (scanning electron microscope) measurement as indicated above. Said preferred porosity degree can already be present in the graphite used for preparing the graphite substrate of the susceptor or the desired porosity degree can be adjusted in further process steps as described below in more detail.

The selection of a porosity degree within the above defined ranges is particularly advantageous with respect to providing the improved SiC coating as described in more detail below.

Preferably, the porous graphite substrate of the susceptor of the invention is a purified, chlorinated and/or activated graphite substrate. Suitable purification and/or chlorination and/or activation can be obtained by carrying out the process steps as described below in more detail.

A further aspect of the invention relates to the susceptor as described anywhere herein, which is coated with silicon carbide (SiC).

In a further aspect of the invention the SiC coating of the susceptor as described anywhere herein is a SiC coating layer further comprising an interfacial layer located between the porous graphite substrate and the SiC coating layer, wherein said interfacial layer comprises the porous graphite and pores filled with SiC in the form of tendrils of at least 50 µm length, wherein said tendrils extend from the SiC coating layer into the porous graphite substrate.

As mentioned above, the term "tendril" or "tendrils" as used in the invention describes deposited SiC material, which is grown to extend from the surface of the porous substrate into the pores and thus extends from the surface of the porous substrate into the deeper regions thereof, e.g. in tendril-like or stretched dimension, thus providing a deep-reaching anchor- or hook-like solid connection of the outer SiC layer extending over the surface of the porous substrate with the porous substrate. To achieve sufficient anchoring the tendrils are allowed to grow into the pores until an average length of at least 50 µm is achieved.

In a further aspect of the invention, said interfacial layer comprises tendrils of an average length of at least 75 µm, preferably at least 100 µm, preferably 75 to 200 µm.

The term "interfacial layer" as used in the invention describes the zone or region, which is located between the porous graphite substrate and the SiC coating layer deposited on the surface of said porous graphite substrate of the susceptor of the invention. Said interfacial layer of the SiC coated susceptors of the invention comprises the porous graphite material of the porous graphite substrate with SiC tendrils extending into the pores. Said interfacial layer extends from the surface of the porous graphite substrate more or less vertically downwards into the porous graphite substrate and thus constitutes the interfacial layer or region. Said interfacial layer preferably has a thickness of at least 100 µm, preferably of > 100 µm, preferably of at least 200 µm, preferably of about 200 to about 500 µm.

Providing such SiC coating with the described interfacial layer provides a SiC coating on the porous graphite substrate with enhanced mechanical properties, such as improved mechanical properties, such as a tight connection (adhesion) of the SiC coating layer to the underlying substrate, high etch resistance, impact resistance, fracture toughness and/or crack resistance of the SiC coating, oxidation resistance of the coated susceptor, as well as improved homogeneity of the SiC coating.

The thickness of the SiC coating on the susceptor can be varied, with a SiC surface layer of at least 30 µm, preferably at least 35 µm, preferably at least 40 µm, preferably at least 45 µm, preferably of up to 50 µm being preferred.

In a further aspect of the invention the interfacial layer as described above exhibits a comparably high degree of pore filling with the deposited SiC material, which is considered to be advantageous to achieve the desired superior mechanical properties as described above. Preferably, the susceptor of the invention comprises the described interfacial layer wherein at least about 70 % of the walls of the open pores of the graphite substrate are coated with the deposited SiC material. For sake of clarity it should be noted that this shall not define that 70 % of the open porous substrate or 70 % of the total amount of the pores of the porous substrate shall be filled with the SiC, neither are 70 % of the volume of the pores filled with SiC. The pore filling degree in accordance with the invention relates to the degree of coating of the inner walls of the open pores, of which preferably at least 70% are coated with a deposited SiC coating. More preferably, at least about 75 %, 80 %, 85 %, 90 % of the inner walls of the open pores are coated with the deposited SiC material.

In a further aspect the susceptor of the invention exhibits a pore filling degree according to the above definition (i.e. a degree of SiC coating of the inner walls of the pores of the graphite substrate) of ≥ 80 % until a depth of about 10 µm from below the main surface of the coated graphite. In a further aspect the susceptor of the invention exhibits a pore filling degree according to the above definition (i.e. a degree of SiC coating of the inner walls of the pores of the graphite substrate) of still ≥ 60 % in a depth of between about 50 to about 10 µm from below the main surface of the coated graphite. In a further aspect the susceptor of the invention exhibits a pore filling degree according to the above definition (i.e. a degree of SiC coating of the inner walls of the pores of the graphite substrate) of about 50 % in a depth of between about 100 to about 50 µm from below the main surface of the coated graphite. In a further aspect the susceptor of the invention exhibits a pore filling degree according to the above definition (i.e. a degree of SiC coating of the inner walls of the pores of the graphite substrate) of about 40 % in a depth of between about 200 to about 100 µm from below the main surface of the coated graphite. In a depth of ≥ 100 µm the pore filling degree according to the above definition is up to 50 %. In a depth of ≥ 200 µm the pore filling degree according to the above definition is up to 40 %. The degree of pore filling according to the invention can be determined by SEM measurement as indicated above.

The SiC coating material of the susceptor of the invention, deposited in the pores in the above described interfacial layer and/or on the surface comprises at least 90 wt.% pure silicon carbide (SiC). Preferably the SiC coating material comprises at least 91 wt.% at least 92 wt.%, at least 93 wt.%, at least 94 wt.%, at least 95 wt.%, or at least 96 wt.% silicon carbide (SiC). More preferably, the SiC coating material comprises at least 97 wt.% SiC, in each case relative to the total weight of the deposited SiC material.

The SiC coating material of the susceptor of the invention, deposited in the pores in the above described interfacial layer and/or on the surface, further comprises not more than about 10 wt.%, not more than about 9 wt.%, not more than about 8 wt.%, not more than about 7 wt.%, not more than about 6 wt.%, not more than about 5 wt.%, or not more than about 4 wt.% free Si. More preferably, the SiC coating material comprises not more than about 3 wt.% free Si, in each case relative to the total weight of the deposited SiC material. In particular, the SiC coating material comprises a high purity.

The aforementioned amounts of (pure) SiC and free Si relate to the SiC material deposited in the pores of the graphite substrate, forming the tendrils and the interfacial layer, and/or depositing on the surface of the graphite substrate, thus forming an outer SiC layer. Accordingly, when referring to SiC in the meaning of e.g. "SiC layer", "SiC coating", "SiC coated susceptor", "SiC (pore) filling" etc. as used herein in any context with the SiC coating material of the susceptor, not necessarily pure SiC is meant but an SiC material, which may comprise the above cited components in the defined amounts, e.g. in particular free SiC and further impurities besides pure SiC may be present therein.

In a further aspect of the invention the susceptor as described above comprises a SiC coating layer in the form of a homogeneous and continuous, essentially impervious layer covering the surface of the graphite substrate. This means, that the SiC coating layer is in particular essentially free of cracks, holes, spallings or other noticeable surface defects and exhibits essentially a continuous thickness over the whole coated surface area (despite the lacks of coating in the first growth phase due to the holding members as described below).

### III. Process

A further aspect of the invention relates to a process for preparing a susceptor as described anywhere herein.

In particular the invention relates to a process for preparing the susceptor (1) as defined above, comprising the following steps
(A) providing a susceptor substrate,
(B) cutting at least one structured area (2) into the surface of the susceptor substrate, wherein the cutting is performed to provide a plurality of placing elements (4) as defined above,
(C) followed by cutting the overall surface of the at least one structured area (2) of step (B) into a convex or concave form.

More particularly, the invention relates to a process for preparing the susceptor (1) as defined above, comprising the steps
(A) providing a graphite substrate,
(B) cutting at least one structured area (2) into the surface of the graphite substrate, wherein the cutting is performed to provide a plurality of placing elements (4) as defined above,
(C) followed by cutting the overall surface of the at least one structured area (2) of step (B) into a convex or concave form.

### Step (A) - Providing the Susceptor Substrate

The substrate may be any suitable susceptor substrate and is preferably a graphite substrate as defined above in detail.

As mentioned above, the susceptor substrate is preferably a graphite substrate, which may be prepared from any suitable graphite element. Step (A) may include the cutting of the graphite into the desired size and shape and/or subjecting the graphite substrate to further treatments, such as in particular a surface treatment for applying a specific surface structure (providing a specific surface roughness and/or evenness).

### Step (B) and (C) - Cutting

In accordance with a further aspect of the invention as described above, the process may further comprise a step of cutting a groove (5) surrounding the at least one structured area (2) into the surface of the graphite substrate.

In the process of the invention the cutting of the susceptor surface to provide the plurality of placing elements in the at least one structured area and/or the surrounding groove (5) may be carried out using conventional cutting tools, such as preferably a high-precision laser, molding cutter or rotary cutter, in particular a 3-axial CNC milling machine can be used.

The cutting is carried out with a suitable cutting program allowing in particular the cutting in gradually increasing depth from the edge of the structured surface to the center thereof to provide placing elements with equal height as described above.

The cutting of the overall surface to provide the convex or concave shape of the at least one structured area may be carried out using conventional cutting tools, such as preferably a high-precision laser, molding cutter or rotary cutter, in particular a 3-axial CNC milling machine can be used.

### Step (D) - SiC Coating

In a further aspect the process according to the invention comprises a further step (D) of coating the susceptor (1) with SiC.

Said SiC coating of step (D) is preferably carried out by chemical vapor deposition (CVD) using dimethyldichlorosilane (DMS) as the CVD silane precursor material.

In a further aspect the process according to the invention is controlled to achieve the formation of the interfacial layer with the SiC filling of the pores of the porous graphite substrate as described above and the subsequent deposition of SiC to form an outer silicon carbide layer on the porous graphite substrate. This can in particular be achieved by chemical vapor deposition of dimethyldichlorosilane (DMS). In principle, the chemical vapor deposition ("CVD", also known as chemical vapor phase deposition "CVPD") is a well-known technique used to produce high quality, high-performance solid materials, such as in particular to produce thin films in the semiconductor industry. Typically, a substrate is exposed to one or more volatile precursors, which react and/or decompose on the substrate surface to produce the desired deposit. CVD is commonly used to deposit silicon, silicon dioxide, silicon nitride as well as silicon carbides. Therein, a wide variety of organosilanes can be used as the volatile CVD precursor, including simple organosilanes, which may be substituted by one or more halogen atoms, such as mono-, di-, tri- and tetramethyl silane and chlorosilanes, including e.g. methyldichlorosilane, methyltrichlorosilane, tetrachlorosilane (SiCl₄), dimethyldichlorosilane, as well as arylsilanes, which may be substituted by halogen atoms. The most common CVD precursor for depositing silicon carbide are trichlorosilane, tetrachlorosilane and methyltrichlorosilane. However, the inventors of the invention have found that surprisingly the advantageous SiC coating with the formation of tendrils as described above can be achieved with the process conditions described herein by using dimethyldichlorosilane ((CH₃)₂SiCl₂; also designated as chlorodimethylsilane, abbreviated as DMS), as the CVD precursor. It turned out that with the specific selection of dimethyldichlorosilane as the CVD precursor instead of e.g. the more common tetrachlorosilane, trichlorosilane or methyltrichlorosilane (MTS, trichloromethylsilane) in the process as described herein it is possible to achieve the improved characteristics of the SiC coated susceptors as described herein, such as e.g. the hereinafter described SiC grain and crystal size, the above described SiC tendril formation and pore filling degree, the formation of the interfacial layer with the described thickness and thus the improved outer SiC coating layer with the improved mechanical properties, homogeneity and continuity etc..

A further aspect of the invention relates to a process for preparing the susceptor as described herein comprising the SiC coating of step (D) with the specific CVD conditions of using dimethyldichlorosilane (DMS) as the silane source or CVD precursor in the presence of H₂ as the purge gas for depositing SiC on a graphite substrate having an open porosity as defined above. This leads to the formation of SiC tendrils as defined above, which grow into the porous structure of the porous graphite substrate, thus extending into the graphite substrate.

Accordingly, a further aspect of the invention relates to a process for manufacturing a silicon carbide (SiC) coated susceptor according to the invention, wherein the additional step (D) of such process comprises the steps
- (D-1): positioning the porous graphite substrate susceptor having an open porosity as defined above, which results from step (C) above, in a process chamber;
- (D-2): heating the porous graphite substrate in the process chamber to a temperature > 1000 °C in the presence of H₂ as purge gas;
- (D-3): introducing a mixture of dimethyldichlorosilane (DMS) and H₂ into the process chamber;
- (D-4): depositing in an infusion phase crystalline SiC grains in the open pores of the graphite substrate by chemical vapor deposition (CVD) and allow growing of the crystalline SiC grains to SiC crystals until tendrils extending with a length of at least 50 µm into the porous graphite substrate are formed;
- (D-5): optionally continuing the chemical vapor deposition until a SiC surface layer of up to 50 µm thickness is deposited on the surface of the graphite substrate in a first growth phase;
- (D-6): cooling the susceptor resulting from step (D-5).

It is particularly preferred to deposit not only SiC tendrils in the pores of the graphite, but also a SiC coating on top of the surface of the graphite substrate with the SiC filled pores. Therefore, step (D-5) - although not mandatory - is preferably also carried out. Certainly, step (D-5) can be controlled to achieve a SiC surface layer of the desired thickness as defined above, e.g. by varying the deposition time and/or the amount of DMS.

It further turned out, that surprisingly in step (D) the formation of the SiC tendrils can significantly be improved or facilitated, if prior to step (D-2) a pre-conditioning step is included, wherein the porous graphite substrate of the susceptor is pre-treated and activated by purging the process chamber with N₂ and heating to a temperature > 1000 °C, and then directly carrying out step (D-2). In principle such pre-treatment step is very similar to the graphite activation process described below in more detail. Such graphite activation process and the CVD method are preferably combined and carried out in the same process chamber. Such pre-conditioning step preferably comprises purging the process chamber with nitrogen until the oxygen content in the process chamber is about 5.0 %, followed by heating the process chamber to a temperature of at least about 1000 °C, until the oxygen content is ≤ 0.5 %, preferably ≤ 0.3 %, preferably ≤ 0.2 %, preferably ≤ 0.1 %. The oxygen content can be controlled using an oxygen / carbon monoxide meter Bacharach Model 0024-7341.

In step (D-3) of the process of the invention the heated porous graphite substrate is subjected to chemical vapor deposition for depositing the silicon carbide in and on the porous graphite substrate. Therein, the mixture of DMS and H₂ according to step (D-3) is preferably obtained by introducing the H₂ gas into the DMS tank, bubbling the H₂ through the DMS in the tank and passing the mixture of DMS and H₂ into the process chamber by purchasing the mixture from the top of the tank. Preferably an amount of 25 - 45 slpm of the mixture is introduced into the process chamber. Preferably, H₂ is directed through the DMS tank and joined with the DMS. A further amount of H₂ may be purged directly into the process chamber, where it joins with the mixture of DMS and H₂. The flow meter for controlling the flow of the DMS / H₂ mixture can be a flow meter of Sierra Instruments Digital MFC. Further steps of heating and purging with H₂ may be carried out prior to the introduction of the DMS. Argon is a common purge gas also in CVD methods, however, the present inventors found, that no tendril formation occurs when using argon as purge gas in the CVD process of the invention (or any other process described herein). Therefore, the process is preferably carried out in the absence of argon.

In the preferred further step (D-5) of the CVD process described herein a SiC layer is further grown on the porous graphite substrate in a first growth phase by continuing chemical vapor deposition of the mixture of dimethyldichlorosilane and H₂, thus covering the graphite substrate surface.

The thus coated SiC graphite substrate may be subjected to a further step of annealing the coated porous graphite substrate by maintaining the coated porous graphite substrate at a temperature of > 1000 °C for reducing stress in the SiC coating and in the porous graphite substrate. Such an annealing step may also be carried out following the pre-conditioning step described above.

Accordingly, such an annealing step can be carried out
- prior to step (D-2) and/or, if present, following the pre-conditioning step as described above,
- and/or prior to step (D-6).

Due to the positioning of the graphite substrate susceptor elements on holding elements said points of contact are not coated with SiC in the CVD process. Therefore, to achieve a homogenous and continuous SiC coating over the whole surface, the following process steps (D-7) and (D-8) may be carried out following step (D-6):
- (D-7): changing the position of the susceptor resulting from step (D-6); and
- (D-8): repeating steps (D-2) and (D-3) in a second growth phase, thereby depositing crystalline SiC grains on the surface of the porous graphite substrate resulting from step (D-6) by chemical vapor deposition (CVD) and allow growing of the crystalline SiC grains to SiC crystals until an outer SiC surface layer is formed.

Preferably, the second growth phase according to step (D-8) is carried out applying the same CVD conditions as in the infusion phase and first growth phase. Therefore, in principle the same applies as defined above for the first growth phase.

An annealing step as described above can also be carried out prior to step (D-8) and/or prior to the cooling step (D-6). A similar cooling step is carried out after the second growth phase of step (D-8). Following the cooling steps, the coated bodies are preferably subjected to a quality inspection and optionally a purification, thereby removing loose particles and/or protruding crystals.

However, preferably, the CVD process as described herein is controlled, so that the SiC layer deposited onto the graphite substrate in the first growth phase in step (D-5) is thicker than the SiC layer deposited onto the graphite substrate in the second growth phase in step (D-8) under the same conditions, in particular with the same DMS amount, and in the same deposition time. This can e.g. be achieved by carrying out the above described pre-conditioning step prior to step (D-2). This must be considered as surprising, as it would be assumed that applying the same amount of DMS in the same time to the porous graphite of step (D-1) would lead to a thinner SiC coating in the first growth phase, as before building up the SiC coating DMS is needed for forming the SiC tendrils, which takes some time prior to building up the coating layer. Without being bound to theory it is assumed that the pre-conditioning step provides an activated surface of the graphite substrate, which provides crystallization points for the SiC crystals and thus accelerates and facilitates the SiC formation in the pores and on the graphite surface.

Such pre-conditioning step may comprise the process steps i) to v) as described below in more detail. It is assumed, that the surface powder layer formed on the graphite substrate in the process steps i) to v) as described below may act as activated surface of the graphite substrate subjected to the CVD treatment in step (D-1) above. The powder on the graphite surface may provide said crystallization points for the SiC crystals and accelerate and facilitate the SiC formation.

In the so-called "infusion phase" very small SiC grains form in the open pores of the porous graphite substrate, which are allowed to grow to SiC crystals to form so-called "tendrils" within the pores. After filling the pores, small SiC grains are deposited on the upper surface of the graphite substrate to start buildup of the outer SiC layer in the so-called "growth phase". The small SiC grains are allowed to grow to SiC crystals to form the outer SiC layer.

According to the invention the term "SiC grain" or "SiC grains" refers to very small crystalline particles formed and deposited in the chemical vapor deposition in step (D-4) and (D-5) and (D-8) by using dimethyldichlorosilane and which mainly comprise silicon carbide. Such SiC grains according to the invention are crystalline and exhibit an average particle size of < 2 µm. In contrast to the above defined SiC grains, according to the invention the term "SiC crystal" or "SiC crystals" refers to bigger crystalline SiC particles and which are formed in step (D-4) and (D-5) and (D-8) by allowing the deposited SiC grains to grow. Such SiC crystals according to the invention similarly mainly comprise silicon carbide and exhibit an average particle size of ≥ 2 µm. Preferably the SiC crystals according to the invention exhibit an average particle size > 2 µm. It is further preferred that the SiC crystals according to the invention exhibit an average particle size of not more than 30 µm. More preferably the SiC crystals according to the invention exhibit an average particle size in the range of about ≥ 2 to ≤ 30 µm. The average particle size according to the invention can be determined by known methods, such as SEM as indicated above.

Accordingly, in a further aspect of the CVD process of the invention the infusion phase of step (D-4) is controlled to effect the formation of (crystalline) SiC grains having an average particle size of < 10 µm can be observed, such as in particular of ≤ 7 µm, more particularly of ≤ 5 µm or even ≤ 4 µm or ≤ 3 µm or even ≤ 2 µm, formed in the pores during the infusion phase. Further, the infusion phase of step (D-3) is controlled to effect the formation of SiC crystals having an average particle size of not more than 30 µm (≥ 2 to ≤ 30 µm), preferably of not more than 20 µm (≥ 2 to ≤ 20 µm), preferably of not more than 10 µm (≥ 2 to ≤ 10 µm) formed in the pores during the infusion phase by allowing the SiC grains to grow.

In a further aspect of the CVD process of the invention the first and second growth phase of step (D-5) and (D-8) are controlled to effect the formation of (crystalline) SiC grains having an average particle size of < 10 µm can be observed, such as in particular of ≤ 7 µm, more particularly of ≤ 5 µm or even ≤ 4 µm or ≤ 3 µm or even ≤ 2 µm on the surface of the graphite substrate during the growth phase and allowing the SiC grains to grow to form SiC crystals having an average particle size of not more than 30 µm, preferably having an average particle size of ≥ 2 to ≤ 30 µm, preferably of not more than 20 µm (≥ 2 to ≤ 20 µm), preferably of not more than 10 µm (≥ 2 to ≤ 10 µm) on the graphite substrate during the growth phase to form the outer SiC layer. A certain amount of SiC grains may also already be formed on the graphite surface during the infusion phase.

In accordance with a further aspect the CVD process of the invention is controlled to deposit in step (D-5) and (D-8) a SiC coating layer in the form of a homogeneous and continuous, essentially impervious layer onto the surface of the graphite substrate. This means, that the SiC coating layer is in particular deposited to be essentially free of cracks, holes, spallings or other noticeable surface defects and exhibits essentially a continuous thickness over the whole coated surface area (despite the lacks of coating in the first growth phase due to the holding members).

The CVD process of step (D) of the invention further comprises a step (D-6) of cooling the SiC coated susceptor.

In a further aspect of the CVD process of step (D) of the invention the inventors surprisingly found, that the purity of the DMS used as the CVD precursor may influence the formation and the length of SiC tendrils as described herein. In particular, the inventors surprisingly found that the content of siloxane impurities in the DMS used as the CVD precursor has a remarkable impact on the desired SiC tendril formation. It has also been found, that the content of certain metal impurities, such as metal elements selected from the group consisting of Na, Mg, Al, Ca, Ti, Cr, Mn, Fe, Co, Ni, Cu, Zn, Mo and W, influences the desired SiC tendril formation. Very particularly, the presence of a certain content of metal element impurities selected from Mn, Cu and/or Zn has been found to have a significant impact on the desired SiC tendril formation. More particularly, the presence of a certain content of siloxane impurities together with a certain content of one or more of the metal element impurities selected from Mn, Cu and/or Zn was found to influence the desired SiC tendril formation significantly. Without being bound to theory it is assumed that the presence of certain amounts of such siloxane impurities, as defined below, leads to the formation of a precipitate or gel in the DMS tank, in the evaporator and/or in the vapour-conducting conduit system, which deteriorates the SiC tendril formation. Very particularly, such undesired gel formation may occur when certain amounts such siloxane impurities and of one or more of the metal element impurities mentioned above are present, such as in particular when certain amounts of such siloxane impurities and of Mn, Cu and/or Zn are present. Also residual moisture or residual water contents may have a further impact on such undesired gel formation. The amounts of such impurities in the DMS precursor material used for the CVD method as defined below have been found as advantageous in view of the desired SiC tendril formation as described herein

Therefore, in a further aspect of the invention in the CVD process of step (D) the dimethyldichlorosilane precursor material comprises
- (D-a): dimethyldichlorosilane (DMS) as the main component and
- (D-b): at least one further component being different from DMS and being a siloxane compound or a mixture of siloxane compounds,
wherein the content of the further component (D-b) is ≤ 2.00 wt.%, relating to the dimethyldichlorosilane precursor material.

Thus, in a further aspect of the invention in the CVD process of step (D) the dimethyldichlorosilane precursor material comprises a content of siloxane compounds (D-b) of ≤ 1.500 wt.%, preferably ≤ 1.000 wt.%, preferably ≤ 0.900 wt.%, preferably ≤ 0.850 wt.%, preferably ≤ 0.800 wt.%, preferably ≤ 0.750 wt.%, preferably ≤ 0.700 wt.%, preferably ≤ 0.600 wt.%, preferably ≤ 0.500 wt.%.

In a further aspect of the invention in the CVD process of step (D) the dimethyldichlorosilane precursor material comprises a content of siloxane compounds (D-b) of not more than 0.500 wt.%, preferably not more than 0.450 wt.%, preferably not more than 0.400 wt.%, preferably not more than 0.375 wt.%.

In a further aspect of the invention in the CVD process of step (D) the dimethyldichlorosilane precursor material comprises ≤ 1.000 wt.% 1,3-dichloro-1,1,3,3,-tetramethyldisiloxane, preferably ≤ 0.850 wt.%, preferably ≤ 0.800 wt.%, preferably ≤ 0.750 wt.%, preferably ≤ 0.725 wt.%, preferably ≤ 0.710 wt.%.

In a further aspect of the invention in the CVD process of step (D) the dimethyldichlorosilane precursor material comprises ≤ 0.200 wt.% 1,3-dichloro-1,1,3,5,5,5,-hexamethyltrisiloxane, preferably ≤ 0.150 wt.%, preferably ≤ 0.140 wt.%, preferably ≤ 0.130 wt.%, preferably ≤ 0.120 wt.%, preferably ≤ 0.110 wt.%.

In a further aspect of the invention in the CVD process of step (D) the dimethyldichlorosilane precursor material comprises ≤ 0.200 wt.% octamethylcyclotetrasiloxane, preferably ≤ 0.190 wt.%, preferably ≤ 0.180 wt.%, preferably ≤ 0.170 wt.%, preferably ≤ 0.160 wt.%.

Also metal element impurities may have an influence on the formation and length of the SiC tendrils.

Therefore, in a further aspect of the invention in the CVD process of step (D) the dimethyldichlorosilane precursor material comprises
- (D-a): dimethyldichlorosilane (DMS) as the main component and
- (D-c): metal elements selected from the group consisting of Na, Mg, Al, Ca, Ti, Cr, Mn, Fe, Co, Ni, Cu, Zn, Mo and W,
wherein the content of the metal elements (D-c) is ≤ 30.00 ppm wt., preferably ≤ 25.00 ppm wt., preferably ≤ 20.00 ppm wt., relating to the dimethyldichlorosilane precursor material.

In a further aspect of the invention in the CVD process of step (D) the dimethyldichlorosilane precursor material comprises
- (D-a): dimethyldichlorosilane (DMS) as the main component and
- (D-c): a metal element selected from Mn,
wherein the content of the Mn metal element (D-c) is < 150 ppb wt., preferably < 100 ppb wt., preferably < 50 ppb wt., preferably < 40 ppb wt., preferably < 30 ppb wt., preferably < 20 ppb wt., preferably the content of Mn is between > 0 and 40 ppb wt., relating to the dimethyldichlorosilane precursor material.

In a further aspect of the invention in the CVD process of step (D) the dimethyldichlorosilane precursor material comprises
- (D-a): dimethyldichlorosilane (DMS) as the main component and
- (D-c): a metal element selected from Cu,
wherein the content of the Cu metal element (D-c) is < 50 ppb wt., preferably < 45 ppb wt., preferably ≤ 40 ppb wt., preferably ≤ 35 ppb wt., preferably ≤ 30 ppb wt., preferably ≤ 25 ppb wt., preferably the content of Cu is between > 0 and 25 ppb wt., relating to the dimethyldichlorosilane precursor material.

In a further aspect of the invention in the CVD process of step (D) the dimethyldichlorosilane precursor material comprises
- (D-a): dimethyldichlorosilane (DMS) as the main component and
- (D-c): a metal element selected from Zn,
wherein the content of the Zn metal element (D-c) is < 50 ppb wt., preferably < 45 ppb wt., preferably ≤ 40 ppb wt., preferably ≤ 35 ppb wt., preferably ≤ 30 ppb wt., preferably ≤ 25 ppb wt., preferably the content of Zn is between > 0 and 25 ppb wt., relating to the dimethyldichlorosilane precursor material.

In a further aspect of the invention in the CVD process of step (D) the dimethyldichlorosilane precursor material comprises
- (D-a): dimethyldichlorosilane (DMS) as the main component and
- (D-c): the metal elements Mn, Cu and Zn,
wherein the content of the Mn, Cu and Zn metal elements (D-c) is as defined in the aspects mentioned above.

In a further aspect of the invention in the CVD process of step (D) the dimethyldichlorosilane precursor material comprises
- (D-a): dimethyldichlorosilane (DMS) as the main component;
- (D-b): at least one further component being different from DMS and being a siloxane compound or a mixture of siloxane compounds as defined in anyone of the aspects described above; and
- (D-c): the metal elements Mn, Cu and Zn,
wherein the content of the siloxane component(s) (D-b) are as defined in anyone of the aspects described above and the content of the Mn, Cu and Zn metal elements (D-c) is as defined in anyone of the aspects described above.

In a further aspect, the DMS with the defined purities is particularly used in a chemical vapor deposition method, which is carried out using H₂ as purge gas. Preferably, therein, the dimethyldichlorosilane precursor material is passed into the reaction chamber in a mixture with H₂. Further, therein the mixture of the dimethyldichlorosilane precursor material and H₂ may be obtained by introducing the H₂ gas into the tank containing the dimethyldichlorosilane precursor material, bubbling the H₂ through the tank and passing the mixture of the dimethyldichlorosilane precursor material and H₂ into the reaction chamber by purchasing the mixture from the top of the tank.

In a further aspect, the dimethyldichlorosilane precursor material is further characterized by a content of one or more of the following elements of

| | |
|---|---|
| calcium | < 60.00 ppb wt., |
| magnesium | < 10.00 ppb wt., |
| aluminium | < 12.00 ppb wt., |
| titanium | < 1.00 ppb wt., |
| chromium | < 60.00 ppb wt., |
| iron | < 25000 ppb wt., |
| cobalt | < 1.00 ppb wt., |
| nickel | < 30.00 ppb wt., |
| zinc | < 40.00 ppb wt., |
| molybdenum | < 10.00 ppb wt.. |

The inventors of the invention further found, that with the specific selection of the CVD conditions as described herein, it is possible to control the CVD method of step (D) to deposit SiC in essentially stoichiometric amounts.

Accordingly, in a further aspect of the invention the CVD process of step (D) is carried out using dimethyldichlorosilane as the silicon source and H₂ to form substantially stoichiometric silicon carbide. The inventors of the invention surprisingly found that the deposition of substantially stoichiometric silicon carbide leads to the formation of smaller SiC grains and crystals. With substantially stoichiometric silicon carbide an average SiC grains and crystal size of < 10 µm can be observed, such as in particular of ≤ 7 µm, more particularly of ≤ 5 µm or even ≤ 4 µm or ≤ 3 µm or ≤ 2 µm. With increasing amount of free Si in the deposited SiC the size of the deposited SiC grains and crystals increases to about 10 µm and more. It is however preferred to deposit the SiC with smaller grains and crystal sizes, as smaller grains and crystals form SiC coatings of higher density, whereas larger grains and crystals form SiC coatings of lower density. Therefore the deposition of substantially stoichiometric silicon carbide is desired. The amount of free Si in the deposited SiC is preferably controlled to be in the range as defined herein, thereby achieving the desired grains and crystal size as defined above.

In a further aspect, said CVD process of step (D) is in particular carried out without adding methane gas.

In a further aspect thereof, said CVD process of step (D) is in particular carried out without using any additional silane source besides dimethyldichlorosilane.

In a further aspect thereof, said CVD process of step (D) is in particular carried out by passing the dimethyldichlorosilane into the reaction chamber in a gaseous mixture with H₂.

In a further aspect thereof, said CVD process of step (D) is in particular carried out by using a mixture of the dimethyldichlorosilane and H₂, which is obtained by introducing the H₂ gas into the tank containing the dimethyldichlorosilane, bubbling the H₂ through the tank and passing the mixture of the dimethyldichlorosilane and H₂ into the reaction chamber by purchasing the mixture from the top of the tank.

In a further aspect thereof, said CVD process of step (D) is in particular carried using DMS, which comprises a content of (total) siloxane impurities of < 2.000 wt.%, preferably ≤ 1.500 wt.%, preferably ≤ 1.000 wt.%, preferably ≤ 0.900 wt.%, preferably ≤ 0.850 wt.%, preferably ≤ 0.800 wt.%, preferably ≤ 0.750 wt.%, preferably ≤ 0.700 wt.%, preferably ≤ 0.600 wt.%, preferably ≤ 0.500 wt.%.

In a further aspect thereof, said CVD process of step (D) is in particular carried using DMS, which comprises a content of
Mn metal element of < 150 ppb wt., preferably < 100 ppb wt., preferably < 50 ppb wt., preferably < 40 ppb wt., preferably < 30 ppb wt., preferably < 20 ppb wt.; and/or
Cu metal element of < 50 ppb wt., preferably < 45 ppb wt., preferably ≤ 40 ppb wt., preferably ≤ 35 ppb wt., preferably ≤ 30 ppb wt., preferably ≤ 25 ppb wt.; and/or
Zn metal element of < 50 ppb wt., preferably < 45 ppb wt., preferably ≤ 40 ppb wt., preferably ≤ 35 ppb wt., preferably ≤ 30 ppb wt., preferably ≤ 25 ppb wt.

In a further aspect thereof, said CVD process of step (D) is in particular carried out by depositing SiC from dimethyldichlorosilane as the precursor material on a porous graphite substrate.

In a further aspect thereof, said CVD process of step (D) is in particular carried out using a porous graphite substrate with an open porosity with a porosity degree of ≥ 6 % and ≤ 15 %, preferably 6 % to 13 %, more preferably 11 to 13 %.

In a further aspect thereof, in said CVD process of step (D) the amount of free Si in the SiC deposited on the graphite substrate comprises not more than about 7 wt.%, preferably not more than about wt. 5 %, more preferably not more than about 3 wt.% free Si.

The inventors of the invention further surprisingly found that under the specific CVD conditions as described herein, the particle size of the SiC grains correlate to the amount of DMS introduced into the reaction chamber. The introduction of lower amounts of DMS surprisingly leads to the formation of smaller grains and crystals, whereas the introduction of larger amounts of DMS surprisingly leads to the formation of larger grains and crystals. Smaller grains and crystals further form SiC coatings of higher density, whereas larger grains and crystals form SiC coatings of lower density. Therewith, the CVD deposition can be controlled to provide multilayer SiC coatings having varying densities.

Accordingly, in a further aspect of the invention the CVD process of step (D) is carried out to manufacture a silicon carbide (SiC) coated susceptor comprising at least two SiC layer of different density, such process comprising the steps
- (D-A): positioning a porous graphite substrate having an open porosity in a process chamber;
- (D-B): heating the porous graphite substrate in the process chamber to a temperature > 1000 °C in the presence of H₂ as purge gas;
- (D-C): depositing in a first deposition phase crystalline SiC grains on the surface of the graphite substrate by introducing a mixture of dimethyldichlorosilane (DMS) and H₂ into the process chamber with a first amount of DMS;
- (D-D): increasing or reducing the amount of DMS and depositing in a second deposition phase crystalline SiC grains on the SiC coated graphite substrate of step (D-C) by introducing a mixture of DMS and H₂ into the process chamber with a second amount of DMS;
- (D-E): optionally repeating step (D-D) one or more times, thereby carrying out one or more additional steps of depositing in one or more additional deposition phases crystalline SiC grains on the SiC coated graphite substrate by introducing a mixture of DMS and H₂ into the process chamber with one or more further amounts of DMS;
- (D-F): cooling the body resulting from step (D-E).

In a further aspect said process further comprises prior to step (D-C) the following step
- D-B-2): introducing a mixture of dimethyldichlorosilane (DMS) and H₂ into the process chamber and depositing in an infusion phase crystalline SiC grains in the open pores of the graphite substrate by chemical vapor deposition (CVD) and allow growing of the crystalline SiC grains to SiC crystals until tendrils extending with a length of at least 50 µm into the porous graphite substrate are formed.

In a further aspect said process comprises the following steps (D-G) and (D-H) following step (D-F):
- (D-G): changing the position of the body resulting from step (D-F); and
- (D-H): repeating step (D-C) and optionally steps (D-D) and (D-E), thereby depositing crystalline SiC grains on the surface of the porous graphite substrate resulting from step (D-F) by chemical vapor deposition (CVD) and allow growing of the crystalline SiC grains to SiC crystals until one or more further SiC layers are formed; followed by
cooling the resulting body.

In a further aspect of said process in the optional step (D-E) the amount of DMS is gradually increased.

In a further aspect of said process in step (D-D) the second amount of DMS is twice as much as the first amount in step (D-C).

In a further aspect of said process in step (D-E) a third deposition phase is carried out with a third amount of DMS, which is three times as much as the first amount in step (D-C).

In a further aspect of said process in step (D-E) a third and fourth deposition phase are carried out with a third and fourth amount of DMS, wherein the fourth amount of DMS is four times as much as the first amount in step (D-C).

In a further aspect of said process the DMS amounts in the deposition phases are controlled to effect the formation of smaller SiC crystals having smaller particle size by introducing a decreased amount of DMS and to effect the formation of larger SiC crystals having a larger particle size by introducing an increased amount of DMS.

In a further aspect of said process the thickness of the SiC coatings deposited in the deposition phases is varied by carrying out the individual deposition phases for varying time periods.

In a further aspect of said process the porous graphite substrate of step (D-A) has a porosity degree of ≥ 6 % and ≤ 15 %, preferably 6 % to 13 %, more preferably 11 to 13 %.

In a further aspect of said process the mixture of DMS and H₂ is obtained by introducing the H₂ gas into the DMS tank, bubbling the H₂ through the DMS in the tank and passing the mixture of DMS and H₂ into the process chamber by purchasing the mixture from the top of the tank.

In a further aspect of said process the dimethyldichlorosilane used for the CVD deposition is characterized by having a content of siloxane impurities as defined above, preferably of < 2.00 wt.%.

In a further aspect of said process the dimethyldichlorosilane used for the CVD deposition is characterized by having a content of metal element impurities as defined above, preferably of Mn, Cu and Zn impurities as defined above.

In a further aspect of said process step (D-B-2) is carried out until tendrils of at least 75 µm length, preferably at least 100 µm length, preferably 75 to 200 µm length are formed.

In a further aspect of said process the infusion phase of step (D-B-2) is carried out until an interfacial layer is formed, comprising the porous graphite with SiC filled pores and having a thickness of at least 50 µm, preferably ate least 75 µm, preferably at least 100 µm, preferably at least 150 µm, preferably at least 200 µm, more preferably about 200 to about 500 µm, wherein the interfacial layer is located between the graphite substrate and the SiC surface layer formed in steps (D-C) to (D-E) and step (D-H).

Accordingly, with the CVD process of step (D) of the invention it is possible to provide an SiC coated susceptor, wherein one or more selected surface areas of the graphite substrate are coated with the outer SiC coating layer. It is also possible to deposit the SiC coating not over a complete surface of the porous graphite substrate but only to selected and discrete areas of a surface of the substrate. This can be achieved e.g. by using a kind of mask as commonly used in established coating techniques.

### Graphite Purification

A further aspect of the invention relates to the process for preparing the susceptor as described herein, preferably (but not mandatorily) comprising the SiC coating of step (D), and wherein (if present) prior to step (D) the graphite substrate is subjected to a purification treatment comprising a heat treatment with nitrogen as purge gas in an atmosphere comprising 5.0 to ≤ 0.5 % oxygen and a chlorination treatment at elevated temperatures.

Such pre-treatment (already mentioned above) or purification treatment of the graphite substrate comprises subjecting the graphite substrate to a purification and chlorination procedure. Therefore, the individual graphite substrate susceptor elements are stacked into a furnace and purged with nitrogen gas under heating to reach about 2000 °C. Chlorine gas is purged into the furnace to carry out the chlorination of the graphite susceptor elements. In principle methods for purifying carbonaceous materials such as graphite to remove metal element impurities by chlorination treatment are well known, e.g. from US 2,914,328, WO 94/27909 or EP 1522523 A1. In the known chlorination treatments argon is often used as the purge gas. However, the inventors of the invention have found, that in a further particular aspect of the invention by applying very specific process conditions, not only purified graphite susceptor elements can be prepared, but also graphite susceptor elements having a modified surface porosity. Such purified graphite susceptor elements with modified surface porosity turned out to be particularly suitable for the use as graphite substrate in the preparation of SiC coated susceptors using the CVD method of step (D) as described herein. Such modified graphite susceptor elements particularly facilitate the formation of the SiC tendrils in the pores of the graphite substrate as described herein.

Therefore, in one aspect the process of the invention comprises a step of preparing a purified graphite susceptor element with a modified surface porosity. Such additional process step comprises the following specific steps
a) providing the graphite susceptor element having an open porosity;
b) purging the graphite susceptor element with nitrogen in a furnace until the oxygen content in the furnace is about 5.0 %;
c) heating the porous graphite susceptor element in the furnace to a temperature of at least about 1000 °C;
d) continuing purging with nitrogen and heating of the porous graphite susceptor element until the oxygen content is ≤ 0.5 %;
e) directly subjecting the porous graphite susceptor element to a chlorination treatment, by
f) increasing the temperature to > 1500 °C and start purging chlorine gas;
g) heating the porous graphite susceptor element in the chlorine atmosphere to a temperature of ≥ 2000 °C.

Surprisingly, it turned out that with such specific process conditions it is possible to provide a purified graphite susceptor element, having a modified surface porosity. Said surface porosity modification becomes apparent compared to the surface porosity of the graphite susceptor element according to step a), i.e. a graphite susceptor element prior to the treatment according to steps b) to g). The modification can be determined e.g. in microphotographs or by SEM (scanning electron microscope) measurement as indicated above. With the described process the surface porosity is modified, e.g. by enlarging the surface pores and forming a surface pore structure providing a kind of funnels or cones, leading inside the porous graphite member. In particular, such surface porosity modification comprises enlarging the open pore diameter in the graphite surface compared to the open pore diameter of the graphite susceptor element according to step a). With such specific process conditions the average open pore diameter in the graphite surface can be increased for at least 35 %, preferably for at least 40 %, preferably for at least 45 %, preferably for at least 50 %, preferably for at least 55 %, preferably for at least 60 %. In particular the average open pore diameter in the graphite surface can be increased for more than 60 %, such as e.g. for 60 to 100 %. Such surface porosity modification provides a modified surface structure, which promotes and supports the formation of SiC tendrils growing into and extending into the pores of the graphite susceptor element, when subjected to the CVD process according to step (D).

In step b) nitrogen is preferably purged until the oxygen content in the furnace is about 3.0 %, preferably about 2.5 %. If the oxygen content in step b) is higher than defined herein before heating the porous graphite susceptor element in step c) the graphite burns off and the pore structure is at least partly destroyed. If the oxygen content in step b) is lower than defined herein before heating the porous graphite susceptor element in step c), then no sufficient modification of the surface porosity can be achieved. The oxygen content can be controlled using an oxygen / carbon monoxide meter Bacharach Model 0024-7341.

In step d) purging with nitrogen and heating is preferably continued until the oxygen content is reduced to ≤ 0.3 %, preferably ≤ 0.2 %, preferably ≤ 0.1 %.

It is also possible to purge with nitrogen without starting to heat the graphite susceptor element until the desired low oxygen content is reached and then start heating the porous graphite susceptor element as defined in step c) above.

Without being bound to theory it is assumed that the purge gas nitrogen and oxygen residues being present in the furnace react to form nitrogen oxides (NOx) during combustion, which are known for their reactivity, and which are thus assumed to further effect a purification of the porous graphite susceptor element.

In one aspect of the specific process step as described herein, the graphite susceptor element having been purged and optionally heated until the desired low oxygen content has been achieved, is directly subjected to the chlorination process by starting to heat the graphite susceptor element as defined in step f).

In step f) and/or g) the chlorine gas is preferably purged with 5 to 20, preferably 7 to 10 slpm slpm (standard liter per minute) chlorine gas. The flow meter for controlling the flow of chlorine gas can be a flow meter of Sierra Instruments Digital MFC.

Preferably, the chlorination treatment of steps e) to g) is carried out for a time period of about 1 to 4 hours, preferably 1 to 3 hours.

Preferably, the chlorination treatment of steps e) to g) is carried out at a temperature of not more than 2600 °C.

Preferably, the chlorination treatment is controlled to adjust a chlorine content in the porous graphite susceptor element to an amount of at least about 20.00 ppb wt., preferably at least about 40.00 ppb wt., preferably at least about 60.00 ppb wt..

In a further aspect, the chlorine content in the porous graphite susceptor element is adjusted to an amount of at least about 30.00 ppb wt., preferably at least about 40.00 ppb wt., preferably at least about 50.00 ppb wt..

In a further aspect, the chlorine content in the porous graphite susceptor element is adjusted to an amount in the range of about 20.00 to 250.00 ppb wt., preferably of about 30.00 to 250.00 ppb wt., preferably of about 40.00 to 250.00 ppb wt., preferably of about 50.00 to 250.00 ppb wt..

In a further aspect, the chlorine content in the porous graphite susceptor element is adjusted to an amount in the range of about 20.00 to 250.00 ppb wt., preferably of about 20.00 to 200.00 ppb wt., preferably of about 20.00 to 175.00 ppb wt., preferably of about 20.00 to 165.00 ppb wt..

Such chlorine content adjustment is particularly preferred in the above described process with the process steps e) to g).

Therein, the adjusted and above defined chlorine content is in particular achieved in the deeper regions of the porous graphite susceptor element and not only in the surface region.

Very particularly, with the chlorination treatment according to the invention the above defined preferred chlorine contents can be achieved inside the porous graphite susceptor element, in particular in a depth of ≥ 50 µm below the main surface. The chlorination content in the depth of the graphite susceptor element is preferred to achieve the desired degree of purity and to introduce chlorine into the g graphite susceptor element. Said adjustment can in particular be achieved with the aforesaid preferred chlorination treatment conditions.

Without being bound to theory it is assumed that introducing chlorine into the graphite susceptor element provides a kind of reservoir of entrapped chlorine, which can achieve a further purification in following process steps as described herein, e.g. in the CVD method of step (D) as described above. To introduce and preserve residual chlorine in the graphite susceptor element the specific porosity degree and/or density of the graphite susceptor element as defined herein is assumed as advantageous. It is assumed, that such comparably dense graphite materials support the entrapping of the chlorine in the graphite susceptor element.

According to the invention the chlorination treatment is carried out to provide a purified porous graphite susceptor element, e.g. a graphite susceptor element resulting from the above described process step g), comprising one or more of the following impurity elements in an amount of

| | |
|---|---|
| calcium | < 100.00 ppb wt., |
| magnesium | < 100.00 ppb wt., |
| aluminum | < 100.00 ppb wt., |
| titanium | < 20.00 ppb wt., |
| chromium | < 200.00 ppb wt., |
| manganese | < 20.00 ppb wt., |
| copper | < 100.00 ppb wt., |
| iron | < 20.00 ppb wt., |
| cobalt | < 20.00 ppb wt., |
| nickel | < 20.00 ppb wt., |
| zinc | < 100.00 ppb wt., |
| molybdenum | < 300.00 ppb wt.; |

preferably comprising one or more of the following impurity elements in an amount of

| | |
|---|---|
| calcium | < 50.00 ppb wt., |
| magnesium | < 50.00 ppb wt., |
| aluminum | < 50.00 ppb wt., |
| titanium | < 10.00 ppb wt., |
| chromium | < 100.00 ppb wt., |
| manganese | < 10.00 ppb wt., |
| copper | < 50.00 ppb wt., |
| iron | < 10.00 ppb wt., |
| cobalt | < 10.00 ppb wt., |
| nickel | < 10.00 ppb wt., |
| zinc | < 50.00 ppb wt., |
| molybdenum | < 150.00 ppb wt.. |

According to the invention the chlorination treatment is carried out to provide a porous graphite susceptor element having a purity of ≥ 98 %, preferably ≥ 99 %.

The purification process according to the invention preferably provides a porous graphite member having a total amount of impurities of ≤ 10.00 ppm wt., preferably ≤ 5.00 ppm wt., preferably ≤ 4.00 ppm wt..

The above described process of purification or purification and surface modification may further comprise a step of annealing the porous graphite susceptor element, thereby maintaining the porous graphite susceptor element at a temperature of > 1000 °C for reducing stress in the porous graphite susceptor element.

The resulting purified porous graphite susceptor element can be subjected to a surface cleaning, thereby removing dust and loose particles from the surface of the treated graphite susceptor element.

In the known chlorination treatments of graphite it is quite usual to use argon as purge gas. The inventors of the invention surprisingly found, that in particular for the preparation of purified graphite susceptor element to be subjected to a CVD method according to step (D) as described herein, wherein the formation of tendrils extending into the pores of the graphite is intended, argon is not suitable as purge gas. In contrast, the inventors found that no tendril formation occurs, if argon has been used as purge gas in the process of purifying the graphite susceptor element. In a further aspect of the invention it is thus preferred to carry out the purification and chlorination process in the absence of argon.

### Graphite Activation (Activation of the Chlorinated Graphite)

A further aspect of the invention relates to the process for preparing the susceptor as described herein, preferably (but not mandatorily) comprising the SiC coating of step (D), and wherein (if present) prior to step (D) the graphite substrate is subjected to an activation treatment comprising a heat treatment with nitrogen as purge gas in an atmosphere comprising 5.0 to ≤ 0.5 % oxygen directly followed by the CVD treatment of step (D) carried out in the same process chamber.

Such further pre-treatment or activation treatment comprises subjecting the graphite susceptor element or the purified and chlorinated graphite susceptor element as described above to an activation procedure. The inventors of the invention surprisingly found, that in this further aspect of the process of the invention the application of very specific process conditions are suitable to prepare an activated graphite susceptor element with (further) modified surface porosity. Such activated graphite susceptor element with modified surface porosity turned out to be particularly suitable for the use as graphite substrate to be SiC coated with the CVD method of step (D) as described above, as such activated graphite susceptor element further facilitates and supports the formation of SiC tendrils extending into the pores of the graphite, when subjected to the CVD treatment of step (D) as described above.

Accordingly, in a further aspect of the invention the process for manufacturing the SiC coated susceptor comprises the step of preparing an activated graphite susceptor element with a modified surface porosity. Such additional process step comprises the specific steps
i) positioning the graphite susceptor element having an open porosity in a process chamber;
ii) purging the graphite susceptor element with nitrogen in the process chamber until the oxygen content in the process chamber is about 5.0 %;
iii) heating the porous graphite susceptor element in the furnace to a temperature of at least about 1000 °C;
iv) continuing purging with nitrogen and heating of the porous graphite susceptor element to a temperature of > 1000 °C until the oxygen content is ≤ 0.5 %.

Such process can be carried out in a process chamber, cladded with graphite. The process chamber may comprise holding elements, onto which the graphite susceptor elements to be treated can be mounted. It is preferred to keep the point(s) of contact between the graphite susceptor elements and the holding elements as small as possible. The process chamber may be heated. In principle, such process chambers are known.

Said process may further comprise a step v) of annealing the activated porous graphite susceptor element by maintaining the activated porous graphite susceptor element at a temperature of > 1000 °C for reducing stress in the activated porous graphite susceptor element following step iv).

The activated porous graphite susceptor element may be cleaned from surface dust or loose particles. However, it is particularly preferred, that the activated porous graphite susceptor elements obtained by said activation process are directly subjected to the chemical vapor deposition treatment of step (D) as described above. Accordingly, the aforesaid process preferably comprises the further step vi), following step iv) or the optional step v), of directly subjecting the activated porous graphite susceptor element to the CVD treatment according to step (D). Therein, it is particularly preferred to omit any cleaning steps between the activation treatment and the CVD treatment, such as described e.g. in US 3,925,577.

Accordingly, in a further aspect the process of the invention comprises a further step of manufacturing an activated graphite susceptor element with a modified surface porosity, which comprises the specific steps
i) positioning the graphite susceptor element having an open porosity in a process chamber;
ii) purging the graphite susceptor element with nitrogen in the process chamber until the oxygen content in the process chamber is about 5.0 %;
iii) heating the porous graphite susceptor element in the furnace to a temperature of at least about 1000 °C;
iv) continuing purging with nitrogen and heating of the porous graphite susceptor element to a temperature of > 1000 °C until the oxygen content is ≤ 0.5 %;
v) optionally annealing the activated porous graphite susceptor element resulting from step iv) at a temperature of > 1000 °C to reduce stress in the activated porous graphite susceptor element; directly followed by step
(D) of subjecting the activated porous graphite susceptor element of step iv) or v) to the CVD treatment as described above without prior cleaning step.

Such activated porous graphite susceptor element being directly subjected to the CVD process according to step (D) without removing dust or loose particles may comprise a kind of powder layer on the surface, such surface powder layer then mainly comprises carbon powder or carbon dust. The porous graphite susceptor element resulting from step iv) or v) may comprise such a surface powder layer having a thickness of 1 to 15 µm, preferably of 2 to 10 µm, preferably of 3 to 7 µm, preferably of > 1 µm, preferably of > 2 µm. Accordingly, the activated porous graphite susceptor element being directly subjected to the CVD treatment in step (D) preferably exhibits a respective surface powder layer.

In step ii) of the activation process described above preferably nitrogen is purged until the oxygen content in the process chamber is about 3.0 %, preferably about 2.5 %. In step iv) purging with nitrogen and heating is preferably continued until the oxygen content is reduced to ≤ 0.3 %, preferably ≤ 0.2 %, preferably ≤ 0.1 %. The oxygen content can be controlled using an oxygen / carbon monoxide meter Bacharach Model 0024-7341.

Similar as in the purification process described above, an oxygen content in step ii) being higher than defined herein before heating the porous graphite susceptor element in step iii) is critical. With a higher oxygen content the graphite may burn off and the pore structure is at least partly destroyed. If the oxygen content in step ii) is lower than defined herein before heating the porous graphite susceptor element in step iii), then no sufficient activation of the graphite susceptor element can be achieved.

Very preferably a purified and chlorinated graphite susceptor element as described above is subjected to the present activation treatment. Therefore, it is particularly preferred that in said activation process the graphite susceptor element of step i) exhibits a chlorine content of at least about 20.00 ppb wt., preferably at least about 40.00 ppb wt., preferably at least about 60.00 ppb wt..

In a further aspect, the chlorine content in the porous graphite susceptor element used in step i) is at least about 30.00 ppb wt., preferably at least about 40.00 ppb wt., preferably at least about 50.00 ppb wt..

In a further aspect, the chlorine content in the porous graphite susceptor element used in step i) is in the range of about 20.00 to 250.00 ppb wt., preferably of about 30.00 to 250.00 ppb wt., preferably of about 40.00 to 250.00 ppb wt., preferably of about 50.00 to 250.00 ppb wt..

In a further aspect, the chlorine content in the porous graphite susceptor element used in step i) is in the range of about 20.00 to 250.00 ppb wt., preferably of about 20.00 to 200.00 ppb wt., preferably of about 20.00 to 175.00 ppb wt., preferably of about 20.00 to 165.00 ppb wt..

Very particularly, said preferred chlorine contents are present inside the porous graphite substrate (constituting the graphite susceptor element), in particular in a depth of ≥ 50 µm below the main surface.

As mentioned above, using graphite susceptor elements with such chlorine contents entrapped inside the graphite substrate are advantageous to achieve a further purification during the present activation treatment.

For the reasons set out above, the porous graphite susceptor element of step i) of the activation process preferably has a porosity degree of ≥ 6 % and ≤ 15 %, preferably about 6 % to about 13 %, preferably of about 11 % to about 13 %.

For the reasons set out above, the porous graphite susceptor element of step i) of the activation process preferably has a density as defined above.

The porous graphite substrate being treated in the activation treatment descried herein can be further purified to the entrapped chlorine content, as explained above. Accordingly, the activated porous graphite susceptor element resulting from the above described process may comprise one or more of the following impurity elements in an amount of

| | |
|---|---|
| calcium | < 100.00 ppb wt., |
| magnesium | < 100.00 ppb wt., |
| aluminum | < 100.00 ppb wt., |
| titanium | < 20.00 ppb wt., |
| chromium | < 200.00 ppb wt., |
| manganese | < 20.00 ppb wt., |
| copper | < 100.00 ppb wt., |
| iron | < 20.00 ppb wt., |
| cobalt | < 20.00 ppb wt., |
| nickel | < 20.00 ppb wt., |
| zinc | < 100.00 ppb wt., |
| molybdenum | < 300.00 ppb wt.. |

preferably comprising one or more of the following impurity elements in an amount of

| | |
|---|---|
| calcium | < 50.00 ppb wt., |
| magnesium | < 50.00 ppb wt., |
| aluminum | < 50.00 ppb wt., |
| titanium | < 10.00 ppb wt., |
| chromium | < 100.00 ppb wt., |
| manganese | < 10.00 ppb wt., |
| copper | < 50.00 ppb wt., |
| iron | < 10.00 ppb wt., |
| cobalt | < 10.00 ppb wt., |
| nickel | < 10.00 ppb wt., |
| zinc | < 50.00 ppb wt., |
| molybdenum | < 150.00 ppb wt.. |

The activated porous graphite susceptor element may have a purity of ≥ 98 %, preferably ≥ 99 %.

The activated porous graphite susceptor element may further have a total amount of impurities of ≤ 10.00 ppm wt., preferably ≤ 5.00 ppm wt., preferably ≤ 4.00 ppm wt..

If the activated porous graphite susceptor element is directly subjected to the chemical vapor deposition treatment of step (D), such CVD treatment can be carried out in the same process chamber. Then, the introduction of H₂ can already be started, if the temperature in the process chamber is > 1000 °C and the oxygen content in the process chamber is below 1.5 %. For example, the process step (D-2) of the CVD method described above can already start, if such oxygen content of below 1.5 % is reached in the process chamber.

It turned out that accordingly treated graphite susceptor elements are particularly suitable to support SiC tendril formation in a CVD method using DMS as described above.

### IV. Use

A further aspect of the invention relates to the use of the susceptor described above and as obtainable by the process as described herein for manufacturing articles for high temperature applications, components for applied materials, components for chip manufacturing etc. such as wafer, semiconductor materials, electronic components etc..

A particular aspect relates to the use of the susceptor described above and as obtainable by the process as described herein for holding a wafer, semiconductor materials, components for chip manufacturing etc. by placing the wafer, semiconductor materials, components for chip manufacturing etc. on the top planes (P2) of the placing elements (4) constituting the surface of the structured area (2) in high temperature treatments.

The invention is further illustrated by the Figures and the following examples without being limited thereto.

### Description of the Figures and the Reference Signs

- (1): susceptor
- (2): structured area
- (3): unstructured area
- (4): placing element(s)
- (5): groove
- (P1): bottom plane of placing element(s)
- (P2): top plane of placing element(s)
- (P3): side plane of placing element(s)
- (L1): bottom level of bottom plane(s) of placing element(s)
- (L2): upper level of top plane(s) of placing element(s)
- (L3): surface level of unstructured area
- (h): perpendicular height of placing element(s)
- (Aₓ): central axis of placing element(s)
- (Aᵢ): inner angle between bottom plane and side plane of placing element(s)
- (Aₒ): outer angle between two adjacent placing elements
- (dₐⱼ): distance between the spaces two adjacent placing elements on bottom level
- (1-A): porous graphite substrate
- (1-B): SiC coating layer
- (1-B-a):
- (1-B-b): SiC coating layers of different density
- (1-B-c):
- (1-C): interfacial layer with
- (1-D): tendrils formed in open pores
- (1-E): SiC coating on the inner walls of open pores
- (1-F): open pores in the graphite substrate

- **Figure 1**: illustrates a schematic view on placing elements (4) in a structured area (2) with overall concave surface of the structured area (2) of the susceptor (1), obtained by conventional methods known from the prior art, resulting in placing elements (4) with decreasing perpendicular height (h; h1 vs. h2) and increasing surface areas of the top planes (P2) from the edge of the structured area (2) to the center thereof, having spaces between two placing elements configured in "V"-form.
- **Figure 2a**: illustrates a schematic view on placing elements (4) in a structured area (2) with overall concave surface of the structured area (2) of the susceptor (1) according to the invention, with the placing elements (4) having equal perpendicular height (h; h1 and h2) and equal surface areas of the top planes (P2) from the edge of the structured area (2) to the center thereof, and having spaces between two placing elements configured in "V"-form.
- **Figure 2b**: illustrates a schematic view on placing elements (4) in a structured area (2) with overall concave surface of the structured area (2) of the susceptor (1) according to the invention, with the placing elements (4) having equal perpendicular height (h; h1 and h2) and equal surface areas of the top planes (P2) from the edge of the structured area (2) to the center thereof, and having spaces between two placing elements with a curved bottom at the bottom level.
- **Figure 2c**: illustrates a schematic detail view of the outer edge of the structured area of the susceptor (1) as illustrated in Figure 2a.

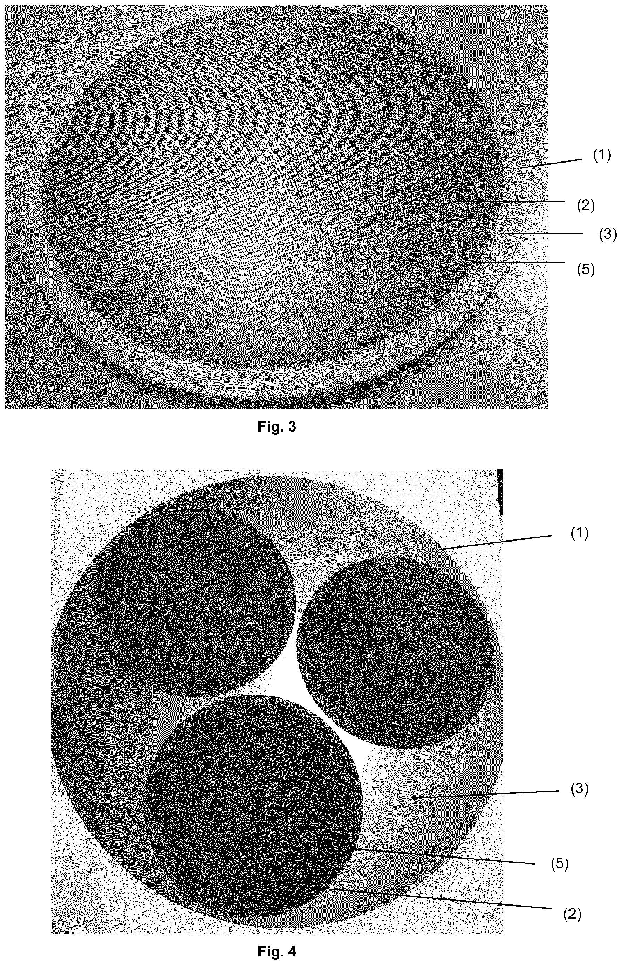

- **Figure 3**: shows a photograph of a susceptor (1) according to the invention comprising an unstructured area (3) and one structured area (2) constituted by the plurality of placing elements and a groove (5) surrounding the structured area (2).
- **Figure 4**: shows a photograph of a susceptor (1) according to the invention comprising three structured areas (2) constituted by the plurality of placing elements surrounded by a groove (5).

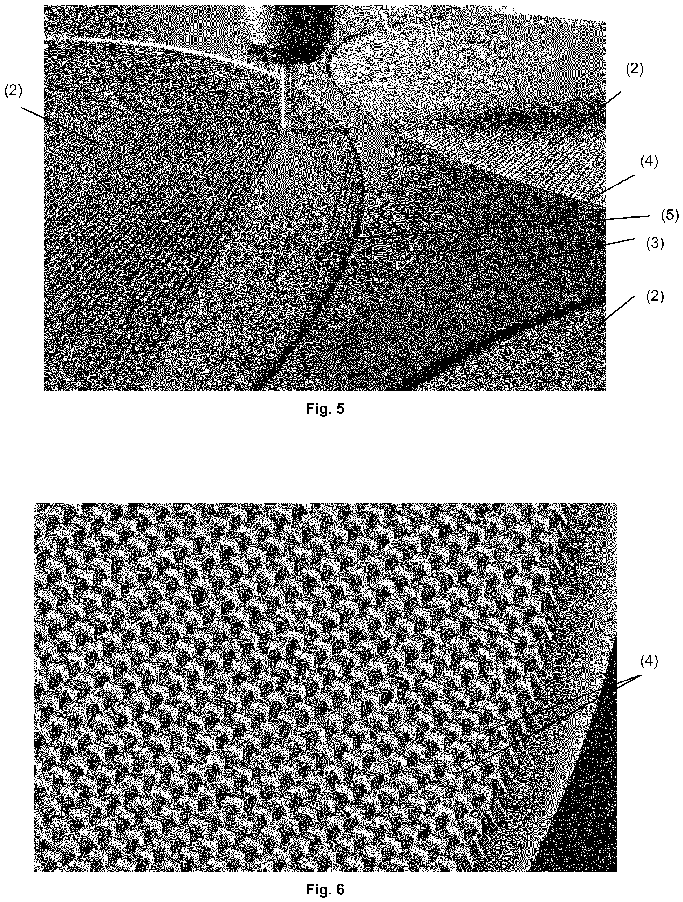

- **Figure 5**: shows a photograph of a detail view on a susceptor according to the invention comprising three structured area (2), wherein in one structured area the cutting of the symmetric grooves to form the plurality of placing elements (4) is only partly finished, whereas a second structured area (2) is already finished and wherein the surrounding groove (5) is shown.
- **Figure 6**: shows an enlarged photograph of the outer edge of structured area of a susceptor according to the invention comprising the plurality of adjacent, symmetric and equal placing elements (4) in the form of frustums.

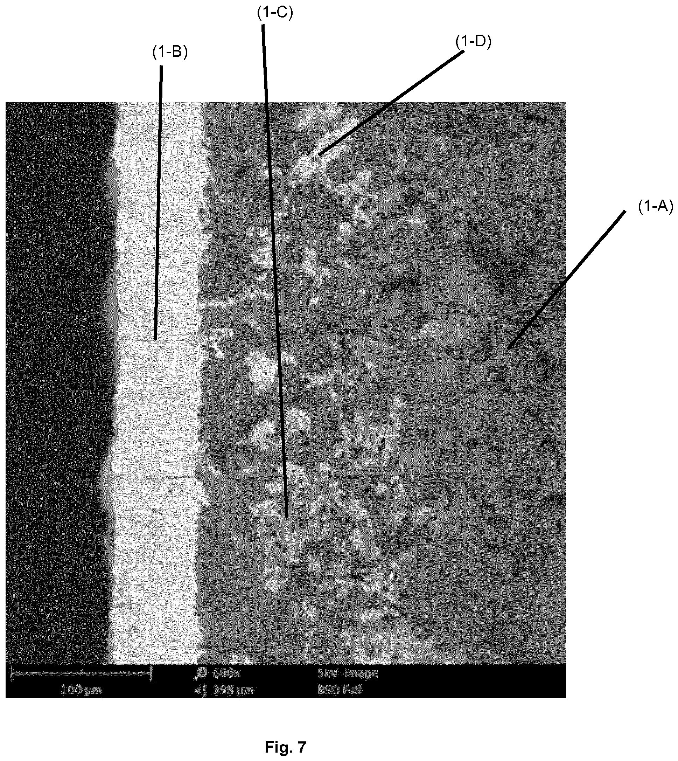

- **Figure 7**: shows a SEM image with a 680 fold magnification of a silicon carbide coated susceptor according to the invention with a graphite substrate (1-A) and SiC tendrils (1-D) in the interfacial layer (1-C) thereof as well as the SiC coating layer (1-B). It can be seen that the interfacial layer (1-C) has a thickness of approximately 200 µm, i.e. SiC tendrils (1-D) extend into the porous graphite substrate (1-A) with a length of at least 50 µm. The SiC coating layer (1-B) has a thickness of approximately 50 µm

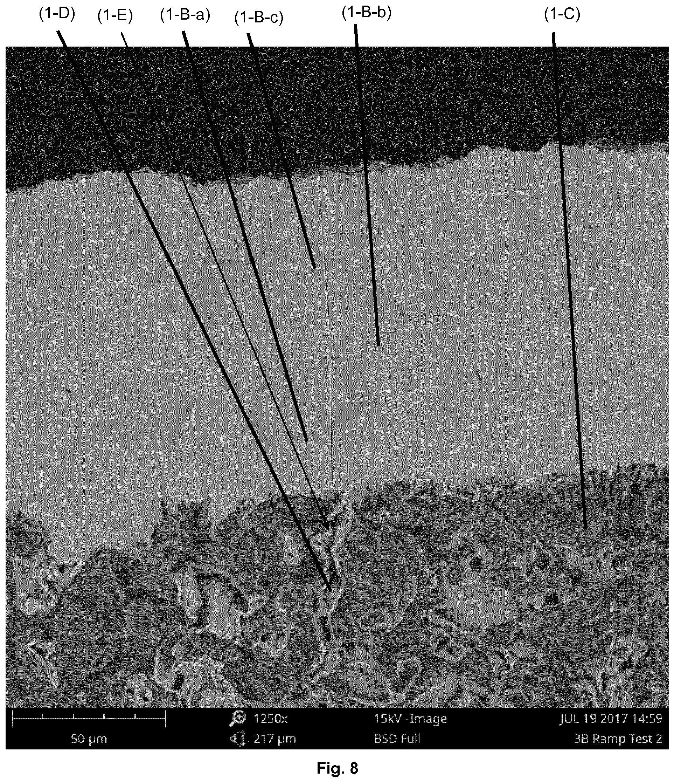

- **Figure 8**: shows a SEM image with a 1250 fold magnification of a silicon carbide coated body with a multilayer SiC coating of different density. The different SiC coating layers exhibit different thickness with a first SiC layer (1-B-a) of approximately 43 µm thickness, a second SiC layer (1-B-b) of approximately 7 µm thickness, and a third SiC layer (1-B-c) of approximately 50 µm thickness. The image further shows the tendrils (1-D) with the SiC pore filling in the form of a SiC coating of the inner walls of the open pores (1-E) in the interfacial layer (1-C).

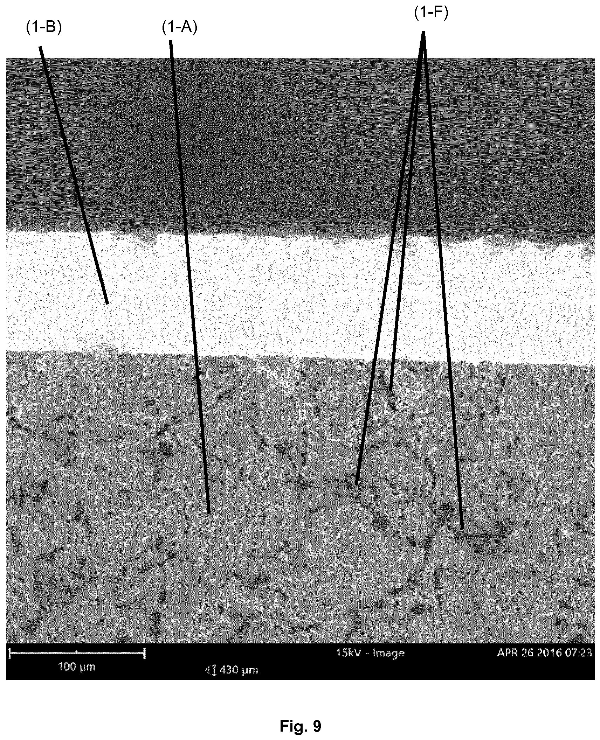

- **Figure 9**: shows a SEM image of a silicon carbide coated body with a SiC coating layer (1-B) of nearly 100 µm thickness on the porous graphite substrate (1-A) but without formation of tendrils and an interfacial layer. The open pores (1-F) of the graphite substrate (1-A) are well apparent.

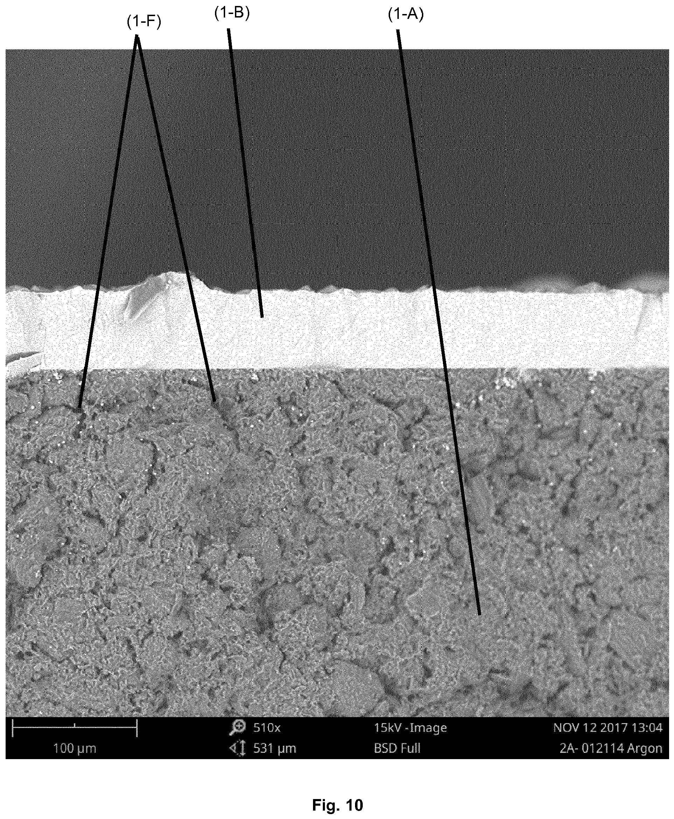

- **Figure 10**: shows a SEM image with a 510 fold magnification of a silicon carbide coated body with a SiC coating layer (1-B) of more than 50 µm thickness on the porous graphite substrate (1-A) but without formation of tendrils and an interfacial layer due to the use of argon as purge gas. The open pores (1-F) of the graphite substrate (1-A) are well apparent.

### V. Examples

Exemplary embodiments of the susceptor according to the invention are shown in Figures 2a, 2b and 2c to 6. Figures 2a, 2b and 2c illustrate a schematic view of the susceptor according to the invention without showing the technical features in true to scale.

### Example 1 - Chlorination of a purified graphite susceptor element

A porous graphite susceptor element was purified and subjected to a chlorination treatment as described in the invention.

The following chlorine content was measured in the chlorinated graphite susceptor element:

| **element** | **graphite susceptor element** |
|---|---|
| Cl | 0.06 ppm wt. |

The chlorinated graphite substrate (1-A) was subjected to the CVD deposition method as described herein.

In the CVD method SiC tendrils (1-D) according to the invention were formed in the pores (1-F) of the accordingly chlorinated graphite substrate (1-A).

### Example 2 - Influence of the Purge Gas on the SiC coating of a Graphite Susceptor

A silicon carbide coated susceptor was prepared with the process of the invention using H₂ as the purge gas.

As a comparative Example, argon was used as purge gas.

As becomes apparent from Fig. 7 and 10, the use of argon does not lead to the formation of tendrils (1-D).

### Example 3 - Multilayer SiC-Coating on a Graphite Susceptor

A silicon carbide coated susceptor was prepared with the process of the invention, therein varying the amounts of DMS for preparing a multilayer SiC coating having varying densities (1-B-a), (1-B-b), (1-B-c) etc..

Therein, the following DMS amounts were introduced into the process chamber of a laboratory size test reactor using H₂ as the carrier gas in the deposition phases:

| **Deposition phase** | **DMS amount** |
|---|---|
| 1. | approximately 0.5 g / minute |
| 2. | approximately 1.0 g / minute |
| 3. | approximately 1.5 g / minute |
| 4. | approximately 2.0 g / minute |

The SiC coatings deposited in the first to fourth deposition phase showed varying crystal sizes, which increased with increasing DMS amounts, leading to SiC coating layers with decreasing density.

A further example, illustrating the SiC multilayer structure due to varying DMS amounts is shown in Figure 8.

### Example 4 - Influence of DMS Purity (Siloxanes) on the SiC coating of a Graphite Susceptor

A silicon carbide coated susceptor was prepared with the process of the invention with DMS of varying siloxane impurities.

DMS with the following amounts of siloxane impurities were used:

| **Siloxane compound** | **DMS Sample A** | **DMS Sample B** | **DMS Sample C** |
|---|---|---|---|
| 1,3-dichloro-1,1,3,3,-tetramethyldisiloxane | 0.193 wt.% | 0.103 wt.% | 0.710 wt.% |
| 1,3-dichloro-1,1,3,5,5,5,-hexamethyltrisiloxane | 0.042 wt.% | 0.072 wt.% | 0.110 wt.% |
| octamethylcyclotetrasiloxane | 0.112 wt.% | 0.157 wt.% | 0.156 wt.% |
| total amount of siloxane impurities | 0.389 wt.% | 0.375 wt.% | 1.04 wt.% |
| total amount of impurities | 0.119 wt.% | 0.580 wt.% | 1.239 wt.% |

With DMS according to sample A and B the formation of SiC tendrils occurred according to the invention.
With DMS according to sample C no sufficient formation of SiC tendrils occurred.

Further, the following ranges were found as effective with respect to the desired tendril formation:

| **Total Siloxane Content** | **Tendril formation** |
|---|---|
| > 2.00 wt.% | - |
| 0.50 to 2.00 wt.% | + |
| < 0.50 wt.% | ++ |

| | |
|---|---|
| "-" represents no or insufficient tendril formation in the open pores "+" represents moderate to low tendril formation in the open pores "++" represents adequate to optimum tendril formation in the open pores | |

### Example 5 - Influence of DMS Purity (Mn) on the SiC coating of a Graphite Susceptor

A silicon carbide coated susceptor was prepared with the process of the invention with DMS of varying manganese impurities.

DMS with the following amounts of manganese impurities were used:

| **metal element** | **DMS Sample A** | **DMS Sample B** | **DMS Sample C** |
|---|---|---|---|
| manganese (Mn) | 2 ppb wt. | 11 ppb wt. | 150 ppb wt. |

With DMS according to sample A and B the formation of SiC tendrils occurred according to the invention.
With DMS according to sample C no sufficient formation of SiC tendrils occurred.

Further, the following ranges were found as effective with respect to the desired tendril formation:

| **Total Manganese Content** | **Tendril formation** |
|---|---|
| ≥ 150 ppb wt. | - |
| 40 to 150 ppb wt. | + |
| < 40 ppb wt. | ++ |

| | |
|---|---|
| "-" represents no or insufficient tendril formation in the open pores "+" represents moderate to low tendril formation in the open pores "++" represents adequate to optimum tendril formation in the open pores | |

### Example 6 - Influence of DMS Purity (Cu) on the SiC coating of a Graphite Susceptor

A silicon carbide coated susceptor was prepared with the process of the invention with DMS of varying copper impurities.

DMS with the following amounts of copper impurities were used:

| **metal element** | **DMS Sample A** | **DMS Sample B** | **DMS Sample C** |
|---|---|---|---|
| copper (Cu) | 1 ppb wt. | 18 ppb wt. | 41 ppb wt. |

With DMS according to sample A and B the formation of SiC tendrils occurred according to the invention.
With DMS according to sample C no sufficient formation of SiC tendrils occurred.

Further, the following ranges were found as effective with respect to the desired tendril formation:

| **Total Copper Content** | **Tendril formation** |
|---|---|
| ≥ 50 ppb wt. | - |
| 30 to < 50 ppb wt. | + |
| < 30 ppb wt. | ++ |

| | |
|---|---|
| "-" represents no or insufficient tendril formation in the open pores "+" represents moderate to low tendril formation in the open pores "++" represents adequate to optimum tendril formation in the open pores | |

### Example 7 - Influence of DMS Purity (Zn) on the SiC coating of a Graphite Susceptor

A silicon carbide coated susceptor was prepared with the process of the invention with DMS of varying zinc impurities.

DMS with the following amounts of zinc impurities were used:

| **metal element** | **DMS Sample A** | **DMS Sample B** | **DMS Sample C** |
|---|---|---|---|
| zinc (Zn) | 1 ppb wt. | 19 ppb wt. | 42 ppb wt. |

With DMS according to sample A and B the formation of SiC tendrils occurred according to the invention.
With DMS according to sample C no sufficient formation of SiC tendrils occurred.

Further, the following ranges were found as effective with respect to the desired tendril formation:

| **Total Zinc Content** | **Tendril formation** |
|---|---|
| ≥ 50 ppb wt. | - |
| 30 to < 50 ppb wt. | + |
| < 30 ppb wt. | ++ |

| | |
|---|---|
| "-" represents no or insufficient tendril formation in the open pores "+" represents moderate to low tendril formation in the open pores "++" represents adequate to optimum tendril formation in the open pores | |

### Example 8 - Influence of DMS Purity (Siloxanes plus Mn plus Cu plus Zn) on the SiC coating of a Graphite Susceptor

The following ranges of total siloxane content in the presence of Mn, Cu and Zn metal impurities were found as effective with respect to the desired tendril formation:

| **Total Siloxane Content** | **Total Manganese Content** | **Total Copper Content** | **Total Zinc Content** | **Tendril formation** |
|---|---|---|---|---|
| > 2.00 wt.% | ≥ 150 ppb wt. | ≥ 50 ppb wt. | ≥ 50 ppb wt. | - |
| 0.50 to 2.00 wt.% | 40 to 150 ppb wt. | 30 to < 50 ppb wt. | 30 to < 50 ppb wt. | + |
| < 0.50 wt.% | < 40 ppb wt. | < 30 ppb wt. | < 30 ppb wt. | ++ |

| | | | | |
|---|---|---|---|---|
| "-" represents no or insufficient tendril formation in the open pores "+" represents moderate to low tendril formation in the open pores "++" represents adequate to optimum tendril formation in the open pores | | | | |

## Claims

1. Susceptor (1), comprising
a) at least one structured area (2) having a structured surface for placing articles for high temperature applications, components for applied materials, components for chip manufacturing, such as wafer, semiconductor materials, electronic components, and preferably a wafer, thereon, and
b) an unstructured area (3) surrounding the at least one structured area (2),
wherein
I) the at least one structured area (2) is constituted by a plurality of placing elements (4),
i. wherein the placing elements (4) are arranged adjacent to each other and wherein
ii. each placing element (4) comprises a bottom plane (P1) on a bottom level (L1) and a top plane (P2) on an upper level (L2), and
iii. the perpendicular height (h) from the bottom plane (P1) on the bottom level (L1) to the top plane (P2) on the upper level (L2) is essentially equal for all placing elements (4) and
II) the overall surface constituted by the placing elements (4) of the at least one structured area (2) on the susceptor (1) is convex or concave.

2. Susceptor according to claim 1, wherein the placing elements (4) have the form of a frustum.

3. Susceptor according to claim 1 or 2, wherein the surface area of the top planes (P2) is essentially equal for all placing elements (4) and / or wherein the surface area of the top planes (P2) of each placing element (4) is between 0.0025 and 0.25 mm².

4. Susceptor according to any one of the preceding claims, wherein the central axes (Aₓ) of the placing elements (4) are parallel to each other.

5. Susceptor according to any one of the preceding claims, wherein the bottom level (L1) of the bottom planes (P1) of the placing elements (4) is below the surface level (L3) of the unstructured area (3) and / or wherein the surface level (L3) of the unstructured area (3) is equal to and / or higher than the upper level (L2) of the top planes (P2) of the placing elements (4)

6. Susceptor according to any one of the preceding claims, wherein the bottom level (L1) of the bottom plane (P1) of the placing elements (4) is gradually descending, relative to the surface level (L3) of the unstructured area (3), from the outer edge to the center of the structured area (2).

7. Susceptor according to any one of the preceding claims, wherein the inner angle (Aᵢ) between the bottom plane (P1) and the side planes (P3) of the placing elements (4) is equal to or smaller than 90°, preferably < 90°, preferably between 30° and 80°.

8. Susceptor according to any one of the preceding claims, wherein the space between two adjacent placing elements (4) on the bottom level (L1) has a curved configuration and wherein preferably the distance (dₐⱼ) between the spaces of two adjacent placing elements (4) on the bottom level (L1) is between 0.10 to 10.00 mm.

9. Susceptor according to any one of the preceding claims, wherein the outer angle (Aₒ) between two adjacent placing elements (4), which spans via the space between the two adjacent placing elements, is between 140° and 45°.

10. Susceptor according to any one of the preceding claims, wherein the perpendicular height from the bottom plane (P1) on the bottom level (L1) to the top plane (P2) on the upper level (L2) for all placing elements (4) is in the range of 0.05 to 0.70 mm.

11. Susceptor according to any one of the preceding claims, wherein each structured area (2) for placing a wafer thereon is surrounded by a groove (5), which preferably has a depth of 0.2 to 1.5 mm and / or a width or in case of a curved groove a diameter of 0.2 to 1.5 mm.

12. Susceptor according to any one of the preceding claims, wherein the susceptor comprises a graphite substrate which is coated with silicon carbide (SiC).

13. The susceptor according to claim 12, wherein the susceptor comprises a porous graphite substrate having an open porosity of ≥ 6 % and ≤ 15 %, preferably 6 % to 13 %, more preferably 11 to 13 %, which is coated with a SiC coating layer, and which has an interfacial layer located between the graphite substrate and the SiC coating layer comprising the porous graphite and pores filled with SiC in the form of tendrils of at least 50 µm length, extending from the SiC coating layer into the porous graphite substrate.

14. A process for preparing the susceptor (1) as defined in any one of the preceding claims comprising the steps
(A) providing a graphite substrate
(B) cutting at least one structured area (2) into the surface of the graphite substrate, wherein the cutting is performed to provide a plurality of placing elements (4) as defined in any one of the preceding claims
(C) followed by cutting the overall surface of the at least one structured area (2) of step (B) into a convex or concave form; and
optionally further cutting a groove (5) surrounding the at least one structured area (2) into the surface of the graphite substrate.

15. The process according to claim 14, further comprising a step (D) of coating the susceptor (1) with SiC, preferably by using chemical vapor deposition (CVD) with dimethyldichlorosilane (DMS) as the CVD precursor material; and
optionally comprising prior to step (D) a purification treatment of the graphite substrate comprising a heat treatment with nitrogen as purge gas in an atmosphere comprising 5.0 to ≤ 0.5 % oxygen and a chlorination treatment at elevated temperatures; and
optionally comprising prior to step (D) an activation treatment of the graphite substrate comprising a heat treatment with nitrogen as purge gas in an atmosphere comprising 5.0 to ≤ 0.5 % oxygen directly followed by the CVD treatment of step (D) carried out in the same process chamber.

16. The use of the susceptor (1) according to anyone of the claims 1 to 13 or as obtainable in a process according to anyone of claims 14 and 15 for manufacturing articles for high temperature applications, components for applied materials, components for chip manufacturing etc. such as wafer, semiconductor materials, electronic components etc.
